# EUROPEAN PATENT APPLICATION

(11) **EP 3 879 346 A1**
(43) Date of publication of application: **15.09.2021**
(21) Application number: 21162292.3
(22) Date of filing: 26.12.2017
(51) Int. Cl.: G03F 7/32, G03F 7/00, G03F 7/004, G03F 7/027

(54) **METHOD FOR PRODUCING LITHOGRAPHIC PRINTING PLATE**

(30) Priority: 28.02.2017 JP 2017037217
(62) Divisional of application: 17898515.6
(71) Applicant: FUJIFILM Corporation, Tokyo 106-8620 (JP)
(72) Inventor: Wariishi, Koji, Shizuoka, 421-0396 (JP); Aizu, Kohei, Shizuoka, 421-0396 (JP)
(74) Representative: Hoffmann Eitle

(57) **Abstract**

A method for producing a lithographic printing plate includes, in this order, a step of preparing a lithographic printing plate precursor having an image-recording layer on a hydrophilic support, a step of exposing the lithographic printing plate precursor in an image shape, and a step of removing a non-exposed portion of the image-recording layer exposed in the lithographic printing plate precursor using a developer, the developer includes a compound having at least one acidic group selected from the group consisting of a phosphate group, a phosphonate group, and a phosphinate group and one or more carboxy groups, a pH of the developer is 5 to 10, and, after the removal step, a step of washing a surface of an obtained lithographic printing plate with water and a step of desensitizing the surface of the obtained lithographic printing plate are not provided.

## Description

The present disclosure relates to a method for producing a lithographic printing plate and particularly to a method for producing a lithographic printing plate that can be processed in a weak acidic to weak alkaline range and is favorable in terms of the dispersion stability of development scum and scratch stain resistance.

Generally, a lithographic printing plate includes a lipophilic image area that receives ink in a printing process and a hydrophilic non-image area that receives dampening water. Lithographic printing is a method in which the properties of water and printing ink that repel each other are used, the lipophilic image area of the lithographic printing plate is used as an ink-receiving portion, the hydrophilic non-image area is used as a dampening water-receiving portion (non-ink-receiving portion), a difference in the adhesive property of ink is caused on the surface of the lithographic printing plate, the ink is absorbed only in the image area, and then the ink is transferred to a body to be printed such as paper, thereby carrying out printing.

In order to produce this lithographic printing plate, in the related art, lithographic printing plate precursors (PS plates) formed by providing lipophilic photosensitive resin layers (a photosensitive layer and an image-recording layer) on a hydrophilic support are broadly used. Generally, a plate is made using a method in which a lithographic printing plate precursor is exposed through an original image such as a lith film, then, a portion that serves as an image area of the image-recording layer is left, the other unnecessary portion of the image-recording layer is dissolved and removed using an alkaline developer or an organic solvent, and the surface of the hydrophilic support is exposed, thereby forming a non-image area, and a lithographic printing plate is obtained.

As described above, in the plate making step of a lithographic printing plate precursor of the related art, a step of dissolving and removing the unnecessary portion of the image-recording layer using a developer or the like after exposure is required; however, from the viewpoint of the environment and safety, there is a requirement of a process using a developer that is more neutral or a small amount of waste liquid. Particularly, in recent years, the disposal of waste liquid that is discharged due to a wet process has become a significant issue of the entire industrial field in consideration of the global environment, and a request for achieving the above-described requirement has been further intensifying.

Meanwhile, in recent years, digitalization techniques that electronically process, store, and output image information using a computer have been broadly distributed, and a variety of new image-output methods adapting to the above-described digitalization techniques have been put into practical use. Accordingly, a computer to plate (CTP) technique in which digitalized image information is carried by highly convergent radiation such as laser light, and a lithographic printing plate precursor is scanned by and exposed to the light, thereby directly manufacturing a lithographic printing plate without using a lith film has been drawing attention. Therefore, it has become one of important technical objects to obtain lithographic printing plate precursors to which the above-described technique is applied.

For example, JP2012-238023A proposes a development method with a process liquid including a specific surfactant containing a nitrogen atom in a molecule having a pH of 2 to 10.

As described above, a decrease in the alkalinity of developers and the simplification of process steps have been strongly demanded in an incremental manner even in the related art in consideration of the global environment. However, a development process step is generally made up of three sequential steps of development using an alkali aqueous solution having a pH of 12 or higher, the flow of an alkaline agent in a water washing bath, and a process using a gum liquid mainly containing a hydrophilic resin, which forces an automatic developing machine to occupy a large space and, furthermore, creates problems in terms of the environment and the running costs such as a problem of processing development waste liquid, water-washing waste liquid, and gum waste liquid.

JP2012-238023A proposes a development method with a process liquid including a specific surfactant containing a nitrogen atom in a molecule having a pH of 2 to 10, which requires a photosensitive composition to contain a binder polymer having a low acid value, and, in the case of development using the process liquid including a specific surfactant, there is a problem in that the scum dispersion stability of a photosensitive layer is poor. In addition, a one-bath process using a process liquid is described in the examples of JP2012-238023A; however, in plates produced using a method in which a development process and a gum-pulling process are carried out at the same time using a single liquid and no water washing step is provided, there is a problem in that scratch stain resistance is insufficient.

As described above, systems in which an alkaline agent is used for development have a problem with the environment, an object of the impartation of a supplementary liquid and a device for supplementing a decrease in the pH caused by the absorption of carbon dioxide and an accompanying increase in the amount of waste liquid, and a problem with the running costs of developers.

In addition, generally, in development in an acidic to weak alkaline range, it is difficult to ensure developability and, additionally, a component of a photosensitive layer in a non-image area region that has been removed is not easily dispersed stably in developers. Therefore, the component of the photosensitive layer is precipitated in a development tank, and, in a case in which a running process is carried out, the precipitated substance is attached to a printing plate under the process as development scum, and there is a problem in that the component is likely to become an image defect. Furthermore, in a method for producing a lithographic printing plate in which a development process and a gum-pulling process are carried out at the same time using a single liquid, there is no water washing step, and thus a component of a photosensitive layer removed using a developer remains on a lithographic printing plate. Therefore, there is a problem with the suppression of stains during printing, particularly, scratch stain resistance.

An object that an embodiment of the present invention attempts to achieve is to provide a method for producing a lithographic printing plate by which lithographic printing plates that are excellent in terms of scratch stain resistance can be obtained.

Means for achieving the above-described objects include the following aspects.
<1> A method for producing a lithographic printing plate comprising in order: a step of preparing a lithographic printing plate precursor having an image-recording layer on a hydrophilic support; a step of exposing the lithographic printing plate precursor in an image shape; and a step of removing a non-exposed portion of the image-recording layer exposed in the lithographic printing plate precursor using a developer, in which the developer includes a compound having at least one acidic group selected from the group consisting of a phosphate group, a phosphonate group, and a phosphinate group and one or more carboxy groups, a pH of the developer is 5 to 10, and after the removal step, a step of washing a surface of an obtained lithographic printing plate with water and a step of desensitizing the surface of the obtained lithographic printing plate are not provided.
<2> The method for producing a lithographic printing plate according to <1>, in which the developer further includes an anionic surfactant and a nonionic surfactant.
<3> The method for producing a lithographic printing plate according to <2>, in which a mass ratio (the nonionic surfactant to the anionic surfactant) between a content of the nonionic surfactant and a content of the anionic surfactant in the developer is 1.2:1.0 to 5.0:1.0.
<4> The method for producing a lithographic printing plate according to <2> or <3>, in which a total content of the nonionic surfactant and the anionic surfactant in the developer is 2% by mass to 20% by mass of a total mass of the developer.
<5> The method for producing a lithographic printing plate according to any one of <1> to <4>, in which the image-recording layer contains an infrared-absorbing colorant, a polymerization initiator, a polymerizable compound, and a binder polymer.
<6> The method for producing a lithographic printing plate according to any one of <1> to <4>, in which the image-recording layer contains an infrared-absorbing colorant, a polymerization initiator, a polymerizable compound, and a particulate polymer compound.
<7> The method for producing a lithographic printing plate according to any one of <1> to <4>, in which the image-recording layer contains an infrared-absorbing colorant and a thermoplastic resin particle.
<8> The method for producing a lithographic printing plate according to any one of <1> to <7>, in which the number of carboxy groups in the compound having at least one acidic group selected from the group consisting of a phosphate group, a phosphonate group, and a phosphinate group and one or more carboxy groups is 2 or more and 10 or less.
<9> The method for producing a lithographic printing plate according to any one of <1> to <8>, in which a content of the compound having at least one acidic group selected from the group consisting of a phosphate group, a phosphonate group, and a phosphinate group and one or more carboxy groups is 0.1% by mass to 10% by mass of the total mass of the developer.
<10> The method for producing a lithographic printing plate according to any one of <1> to <9>, in which the developer does not include a water-soluble polymer compound or a content of the water-soluble polymer compound is more than 0% by mass and 0.05% by mass or less of the total mass of the developer.

According to an embodiment of the present invention, it is possible to provide a method for producing a lithographic printing plate by which lithographic printing plates that are excellent in terms of scratch stain resistance can be obtained.

### BRIEF DESCRIPTION OF THE DRAWINGS

Fig. 1 is a schematic cross-sectional view illustrating an example of a developing machine that is preferably used in a method for producing a lithographic printing plate according to an embodiment of the present disclosure.
Fig. 2 is a schematic cross-sectional view illustrating another example of the developing machine that is preferably used in the method for producing a lithographic printing plate according to the embodiment of the present disclosure.
Fig. 3 is a graph illustrating an example of an alternation waveform current waveform chart that is used in an electrochemical roughening process used for production of a support.
Fig. 4 is a side view illustrating an example of a radial cell in the electrochemical roughening process in which an alternating current used for production of the support is used.
Fig. 5 is a schematic view of an anodization process device that is used in an anodization process used for production of the support.

Hereinafter, the content of the present disclosure will be described in detail. A constituent requirement described below will be described on the basis of a typical embodiment of the present disclosure in some cases, but the present disclosure is not limited to such an embodiment.

Meanwhile, in the specification of the present application, a numerical range expressed using "to" includes values described before and after "to" as a lower limit value and an upper limit value.

In addition, regarding the expression of a group (atomic group) in the specification of the present application, in a case in which there is no description of whether the group is substituted or unsubstituted, the group refers not only to a group having no substituent but also to a group having a substituent. For example, "alkyl group" refers not only to an alkyl group having no substituent (unsubstituted alkyl group) but also to an alkyl group having a substituent (substituted alkyl group).

In addition, in the present disclosure, "% by mass" and "% by weight" have the same meaning, and "parts by mass" and "parts by weight" have the same meaning.

Furthermore, in the present disclosure, a combination of two or more preferred aspects is a more preferred aspect.

In the present disclosure, the term "main chain" refers to a relatively longest bond chain in a molecule of a polymer compound that constitutes a resin, and the term "side chain" refers to a molecular chain that is branched from the main chain.

In the present disclosure, the term "water-insoluble" indicates that a substance does not dissolve in water at 25°C or dissolves in an amount of less than 0.1% by mass even in the case of dissolving, and the term "soluble in an alkali aqueous solution" indicates that a compound dissolves in an alkali aqueous solution (pH: 10) at 25°C in an amount of 0.1% by mass or more.

In addition, unless particularly otherwise described, the weight-average molecular weight (Mw) and the number-average molecular weight (Mn) in the present disclosure refers to a molecular weight that is detected using a gel permeation chromatography (GPC) analyzer in which columns of TSKgel GMHxL, TSKgel G4000HxL, and TSKgel G2000HxL (all are trade names manufactured by Tosoh Corporation) are used, solvent tetrahydrofuran (THF), and a differential refractometer and is converted using polystyrene as a standard substance.

Hereinafter, the present disclosure will be described in detail.

### (Method for producing lithographic printing plate)

A method for producing a lithographic printing plate according to an embodiment of the present disclosure includes a step of preparing a lithographic printing plate precursor having an image-recording layer on a hydrophilic support, a step of exposing the lithographic printing plate precursor in an image shape, and a step of removing a non-exposed portion of the image-recording layer exposed in the lithographic printing plate precursor using a developer in this order, in which the developer includes a compound having at least one acidic group selected from the group consisting of a phosphate group, a phosphonate group, and a phosphinate group and one or more carboxy groups (hereinafter, also referred to as "specific compound"), a pH of the developer is 5 to 10, and, after the removal step, a step of washing a surface of an obtained lithographic printing plate with water and a step of desensitizing the surface of the obtained lithographic printing plate are not provided.

As described in JP2012-238023A, the present inventors found that, in the production of lithographic printing plates of the related art, in the case of producing lithographic printing plates using a method not including a water washing step in which a development process and a gum-pulling process are carried out at the same time using a single liquid, the obtained lithographic printing plates have a problem in that stains are likely to be attached to scratches on the surface of the plates and the scratch stain resistance is insufficient.

In addition, the present inventors found that, in development in an acidic to weak alkaline range (particularly, a pH range of 5 to 10), as described above, a component of a photosensitive layer in a non-image area region that has been removed is not easily dispersed stably in developers, the component of the photosensitive layer is precipitated in a development tank, the precipitated substance is attached to a plate under the process, particularly, a scratch portion on the surface of the plate as development scum, and there is a problem with the scratch stain resistance.

As a result of intensive studies, the present inventors found that it is possible to provide a method for producing a lithographic printing plate by which lithographic printing plates that are excellent in terms of scratch stain resistance can be obtained by providing the above-described constitution.

An action mechanism of an excellent effect of the above-described constitution is not clear, but is assumed as described below.

It is assumed that, in the case of adding a compound having at least one acidic group selected from the group consisting of a phosphate group, a phosphonate group, and a phosphinate group and one or more carboxy groups to a developer having a pH of 5 to 10, the two kinds of acidic groups in the compound act in a concerted manner, the dispersibility of the development scum in the developer is improved, the specific compound is adsorbed to the surface of the lithographic printing plate, particularly, a scratched portion, and the surface is hydrophilized, which suppresses the attachment of ink, whereby lithographic printing plates that are excellent in terms of scratch stain resistance can be obtained.

### <Preparation step>

The method for producing a lithographic printing plate according to the embodiment of the present disclosure includes a step of preparing a lithographic printing plate precursor having an image-recording layer on a hydrophilic support.

The lithographic printing plate precursor that is used in the present disclosure essentially has a hydrophilic support and an image-recording layer provided on the hydrophilic support and may have an interlayer between the hydrophilic support and the image-recording layer and may further have a protective layer on the image-recording layer. In addition, a backcoat layer may be provided on a surface of the hydrophilic support on a side opposite to the side provided with the image-recording layer.

Hereinafter, the constitution of the lithographic printing plate precursor that is used in the method for producing a lithographic printing plate according to the embodiment of the present disclosure will be described.

### - Hydrophilic support -

The hydrophilic support that is used in the present disclosure is a support having at least one hydrophilic surface. A material of this support is not particularly limited, but needs to be a support having a hydrophilic surface and is preferably a dimensionally stable plate-like material. For example, paper, paper laminated with plastic (for example, polyethylene, polypropylene, polystyrene, or the like), metal plates (for example, aluminum, zinc, copper, and the like), plastic films (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, and the like), paper or plastic films laminated or deposited with the above-described metal, and the like are exemplified. As the support, a polyester film or an aluminum plate is preferred. In a case in which these supports are not sufficiently hydrophilic, the supports are used after a hydrophilization process is carried out on the surface. As the hydrophilization process, the coating of the surface with a hydrophilic layer and a hydrophilization process of the surface of the support are exemplified.

Examples of the aluminum plate include a pure aluminum plate, an alloy plate including aluminum as a main component and a small amount of a different element, and an aluminum or aluminum alloy thin film laminated with plastic. As the different element that is included in the aluminum alloy, silicon, iron, manganese, copper, magnesium, chromium, zinc, bismuth, nickel, titanium, and the like are exemplified. The content of the different element in the alloy is preferably 10% by mass or less. The thickness of the aluminum plate is preferably 0.1 mm to 0.6 mm, more preferably 0.15 mm to 0.4 mm, and still more preferably 0.2 mm to 0.3 mm.

The hydrophilic support that is used in the present disclosure is preferably an aluminum support having a hydrophilic surface. Particularly, an aluminum plate on which a surface treatment such as a roughening process, an anodization process, a hydrophilization process, or the like has been carried out using a well-known method is preferred.

The material that can be used as the support and the roughening process, the anodization process, and the hydrophilization process are well-known, and it is possible to appropriately select and carry out, for example, an enlargement process or sealing process of micropores in an anodized film described in JP2001-253181A or JP2001-322365A, a surface hydrophilization process using an alkali metal silicate as described in each of the specifications of US2,714,066A, US3,181,461A, US 3,280,734A, and US3, 902,734A or polyvinyl phosphoate described in each of the specifications of US3,276,868A and US4,689,272A, or a method described in JP2002-096573A, JP2003-211859A, JP2006-309160A, and JP2006-047742A.

To the hydrophilic support that is used in the present disclosure, it is possible to provide a backcoat layer including an organic polymer compound described in JP1993-045885A (JP-H05-045885A) or an alkoxy compound of silicon described in JP1994-03 5174A (JP-H06-035174A) on a rear surface (a surface opposite to the surface provided with the image-recording layer) as necessary.

From the viewpoint of favorable adhesiveness to the image-recording layer or the interlayer, favorable printing resistance, favorable stain resistance, and the like, the center line average roughness of the hydrophilic support is preferably in a range of 0.10 to 1.2 µm. In addition, regarding the color density of the support, from the viewpoint of a favorable image-recording property by antihalation during image exposure, a favorable plate inspection property after development, and the like, the reflected density value is preferably 0.15 to 0.65.

### - Image-recording layer, interlayer, and protective layer -

The lithographic printing plate precursor that is used in the present disclosure has the image-recording layer as an essential layer on the hydrophilic support, and, for example, individual components and individual aspects of image-recording layers, interlayers, and protective layers described in JP2009-229944A and WO2015/129504A are preferably exemplified.

The image-recording layer is preferably a negative-type image-recording layer and more preferably an image-recording layer containing an infrared absorber, a polymerization initiator, an ethylenically unsaturated compound, and a binder polymer.

In addition, the image-recording layer is more preferably an image-recording layer containing an infrared absorber, a polymerization initiator, an ethylenically unsaturated compound, and a particulate polymer compound.

Furthermore, the image-recording layer is also more preferably an image-recording layer containing an infrared absorber and a thermoplastic resin particle.

Regarding the infrared absorber, the polymerization initiator, the ethylenically unsaturated compound, the binder polymer, the particulate polymer compound, the thermoplastic resin particle, and other components, it is possible to refer to Paragraphs 0039 to 0132 of JP2009-229944A and Paragraphs 0062 to 0225 of WO2015/129504A.

### «Infrared absorber»

The infrared absorber has a function of converting the absorbed infrared rays to heat and a function of performing either or both of electron migration or energy migration to the polymerization initiator or the thermoplastic resin particle described below by being excited by infrared rays. The infrared absorber that is used in the present disclosure is preferably a dye or pigment having the maximum absorption in a wavelength range of 760 nm to 1,200 nm and more preferably a dye.

As the dye, it is possible to use a commercially available dye and a well-known dye described in publications, for example, "Dye Handbooks" (edited by the Society of Synthetic Organic Chemistry, Japan and published on 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, as preferred dyes, a cyanine colorant, a squarylium colorant, a pyrylium salt, a nickel thiolate complex, or an indolenine cyanine colorant is exemplified. Furthermore, a cyanine colorant or an indolenine cyanine colorant is more preferred, and a cyanine colorant is particularly preferred.

Specific examples of the cyanine colorant that can be preferably used include a compound described in Paragraphs 0017 to 0019 of JP2001-133969A, a compound described in Paragraphs 0016 to 0021 of JP2002-023360A and Paragraphs 0012 to 0037 of JP2002-040638A, preferably, a compound described in Paragraphs 0034 to 0041 of JP2002-278057A and Paragraphs 0080 to 0086 of JP2008-195018A, and, most preferably, a compound described in Paragraphs 0035 to 0043 of JP2007-090850A.

In addition, it is also possible to preferably use a compound described in Paragraphs 0008 and 0009 of JP1993-005005A (JP-H05-005005A) and Paragraphs 0022 to 0025 of JP2001-222101A.

As the pigment, it is possible to use commercially available pigments and pigments described in Color Index International (C. I.) handbook, "Advanced Pigment Handbook" (edited by Japan Association of Pigment Technology, published in 1977), "Advanced Pigment Application Techniques" (CMC Publishing Co., Ltd., published in 1986), and "Printing Ink Technique" (CMC Publishing Co., Ltd., published in 1984).

The particle diameter of the pigment is preferably 0.01 µm to 1 µm and more preferably 0.01 µm to 0.5 µm. In order to disperse the pigment, it is possible to use a well-known dispersion technique that is used for the manufacturing of ink, the manufacturing of toner, and the like. The detail is described in "Advanced Pigment Application Techniques" (CMC Publishing Co., Ltd., published on 1986), and the like.

Only one infrared absorber may be used or two or more infrared absorbers may be jointly used.

The content of the infrared absorber is preferably 0.05% by mass to 30% by mass, more preferably 0.1% by mass to 20% by mass, and still more preferably 0.2% by mass to 10% by mass of the total mass of the image-recording layer.

### «Polymerization Initiator»

The polymerization initiator is a compound that initiates and accelerates the polymerization of polymerizable compounds. As the polymerization initiator, it is possible to use a thermal polymerization initiator, a compound having a bond with a small bond dissociation energy, a photopolymerization initiator, or the like that is well-known.

Specifically, as the polymerization initiator, for example, (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfone compound, (j) an oxime ester compound, and (k) an onium salt compound are exemplified.

As the organic halide (a), a compound described in Paragraphs 0022 and 0023 of JP2008-195018A is preferred.

As the carbonyl compound (b), a compound described in Paragraph 0024 of JP2008-195018A is preferred.

As the azo compound (c), for example, an azo compound described in JP1996-108621A(JP-H08-108621A) can be used.

As the organic peroxide (d), for example, a compound described in Paragraph 0025 of JP2008-195018A is preferred.

As the metallocene compound (e), for example, a compound described in Paragraph 0026 of JP2008-195018A is preferred.

As the azide compound (f), a compound such as 2,6-bis(4-azidobenzylidene)-4-methylcyclohexanone can be exemplified.

As the hexaarylbiimidazole compound (g), for example, a compound described in Paragraph 0027 of JP2008-195018A is preferred.

As the organic borate compound (h), for example, a compound described in Paragraph 0028 of JP2008-195018A is preferred.

As the disulfone compound (i), a compound described in each of JP1986-166544A (JP-S61-166544A) is exemplified.

As the oxime ester compound (j), for example, a compound described in Paragraphs 0028 to 0030 of JP2008-195018A is preferred.

As the onium salt compound (k), for example, onium salts such as diazonium salts described in S. I. Schlesinger, Photogr. Sci. Eng., 18, 387 (1974), T. S. Bal et al, Polymer, 21, 423 (1980), and JP1993-158230A (JP-H05-158230A), ammonium salts described in the specification of US4,069,055A, JP1992-365049A (JP-H04-365019A), and the like, phosphonium salts described in the respective specifications of US4,069,055A and US4,069,056A, iodonium salts described in the respective specifications of EP104,143A and US2008/0311520A, JP1990-150848A (JP-H02-150848A), JP2008-195018A, or J. V. Crivello et al, Macromolecules, 10 (6), 1307 (1977), sulfonium salts described in the respective specifications of EP370, 693A, EP233,567A, EP297,443A, EP297,442A, US4,933,377A, US4,760,013A, US4,734,444A, US2,833,827A, DE2,904,626A, DE3,604,580A, and DE3,604,581A, a selenonium salt described in J. V. Crivello et al, J. Polymer Sci., Polymer Chem. Ed., 17, 1047 (1979), an arsonium salt described in C. S. Wen et al, Teh, Proc. Conf. Rad. Curing ASIA, p478 Tokyo, Oct (1988), and an azinium salt described in JP2008-195018A are exemplified.

Among these, the onium salt compound is preferred, and the iodonium salt compound or the sulfonium salt is more preferred.

An example of the iodonium salt is preferably a diphenyl iodonium salt, particularly, preferably a diphenyl iodonium salt substituted with an electron-donating group, for example, an alkyl group or an alkoxyl group, and more preferably an asymmetric diphenyl iodonium salt. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, bis(4-t-butylphenyl)iodonium=tetraphenyl borate, and the like.

As examples of the sulfonium salt, triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and the like are exemplified.

In addition, the organic borate compound is also preferably used. Specific examples of the organic borate compound include tetraphenyl borate salt, tetratolyl borate salt, tetrakis(4-methoxyphenyl) borate salt, tetrakis(pentafluorophenyl) borate salt, tetrakis(3,5-bis(trifluoromethyl)phenyl) borate salt, tetrakis(4-chlorophenyl) borate salt, tetrakis(4-fluorophenyl) borate salt, tetrakis(2-thienyl) borate salt, tetrakis(4-phenylphenyl) borate salt, tetrakis(4-t-butylphenyl) borate salt, ethyltriphenyl borate salt, butyl triphenyl borate salt, and the like. From the viewpoint of satisfying all of printing resistance, tone reproducibility, and temporal stability, tetraphenyl borate salt is preferred. As a counter cation of the borate compound, well-known cations such an alkali metal cation, an alkaline earth metal cation, an ammonium cation, a phosphonium cation, a sulfonium cation, an iodonium cation, a diazonium cation, and an azinium cation are exemplified.

Only one polymerization initiator may be used or two or more polymerization initiators may be jointly used.

The content of the polymerization initiator is preferably 0.1% by mass to 50% by mass, more preferably 0.5% by mass to 30% by mass, and particularly preferably 0.8% by mass to 20% by mass of the total mass of the image-recording layer. Within this range, favorable sensitivity and more favorable resistance to contamination of the non-image area during printing can be obtained.

### «Polymerizable compound»

A polymerizable compound is an addition polymerizable compound having at least one ethylenically unsaturated bond and is selected from compounds preferably having at least one terminal ethylenically unsaturated bond and more preferably having two or more ethylenically unsaturated bonds. These compounds have a chemical form of, for example, a monomer, a prepolymer, that is, a dimer, a trimer, or an oligomer, a mixture thereof, or the like.

As examples of the monomer, unsaturated carboxylic acids (for example, acrylic acid, methacrylic acid, itaconic acid, crotonic acid, isocrotonic acid, maleic acid, and the like), esters thereof, and amides thereof are exemplified, and an ester of an unsaturated carboxylic acid and a polyvalent alcohol compound and amides of an unsaturated carboxylic acid and a polyvalent amine compound are preferably used. In addition, unsaturated carboxylic acid esters having a nucleophilic substituent such as a hydroxy group, an amino group, or a mercapto group, addition reaction product between an amide and a monofunctional or polyfunctional isocyanate or epoxy, and dehydration condensation reaction product of a monofunctional or polyfunctional carboxylic acid, and the like are also preferably used. In addition, addition reaction product between an unsaturated carboxylic acid ester or amide having an electrophilic substituent such as an isocyanate group or an epoxy group and a monofunctional or polyfunctional alcohol, amine, or thiol and, furthermore, substitution reaction product between an unsaturated carboxylic acid ester or amide having a desorptive substituent such as a halogen group or a tosyloxy group and a monofunctional or polyfunctional alcohol, amine, or thiol are also preferred.

In addition, as different examples, a group of compounds substituted with an unsaturated phosphoric acid, styrene, a vinyl ether, or the like instead of the unsaturated carboxylic acid can also be used. These compounds are described in references including JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-064130A, JP2003-280187A, and JP1998-333321A(JP-H10-333321A).

As specific examples of the ester of a polyvalent alcohol compound and an unsaturated carboxylic acid as the monomer, examples of acrylic acid esters include ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, polyester acrylate oligomers, and the like. Examples of methacrylic acid esters include tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl] dimethyl methane, bis-[p-(methacryloxyethoxy)phenyl] dimethyl methane, and the like. In addition, specific examples of monomers of amides of polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like.

In addition, urethane-based addition polymerizable compounds produced using an addition reaction between an isocyanate and a hydroxy group are also preferred, and specific examples thereof include vinyl urethane compounds having two or more polymerizable vinyl groups in one molecule obtained by adding a vinyl monomer having a hydroxy group represented by Formula (b) to a polyisocyanate compound having two or more isocyanate groups in one molecule which is described in, for example, JP1973-041708B (JP-S48-041708B).

CH₂=C(R^{b4})COOCH₂CH(R^{b5})OH (b)

Here, R^{b4} and R^{b5} represent a hydrogen atom or a methyl group.

In addition, urethane acrylates described in JP1976-037193A (JP-S51-037193A), JP1990-032293B (JP-H02-032293B), JP1990-016765B (JP-H02-016765B), JP2003-344997A, and JP2006-065210A, urethane compounds having an ethylene oxide-based skeleton described in JP1983-049860B (JP-S58-049860B), JP1981-017654B (JP-S56-017654B), JP1987-039417B (JP-S62-039417B), JP1987-039418B (JP-S62-039418B), JP2000-250211A, and JP2007-094138A, and urethane compounds having a hydrophilic group described in US7153632B, JP1996-505958A (JP-H08-505958A), JP2007-293221A, and JP2007-293223A are also preferred.

Among these, from the viewpoint of an excellent balance between a hydrophilicity affecting developability and a polymerization capability affecting printing resistance, isocyanuric acid ethylene oxide-modified acrylates such as tris(acryloyloxyethyl) isocyanurate and bis(acryloyloxyethyl) hydroxyethyl isocyanurate are particularly preferred.

Only one polymerizable compound may be used or two or more polymerizable compounds may be jointly used.

The details of the structure of the polymerizable compound and methods for using the polymerizable compound such as whether to use the polymerizable compound singly or jointly and the amount of the polymerizable compound added can be randomly set according to the final performance design of the lithographic printing plate precursor.

The content of the polymerizable compound is preferably 5% by mass to 75% by mass, more preferably 10% by mass to 70% by mass, and particularly preferably 15% by mass to 60% by mass of the total mass of the image-recording layer.

### «Binder polymer»

The binder polymer is used mainly for the purpose of improving the film hardness of the image-recording layer. As the binder polymer, well-known binder polymers of the related art can be used, and polymers having a film property are preferred. Among these, an acrylic resin, a polyvinyl acetal resin, or a polyurethane resin is preferred.

As a preferred binder polymer, a binder polymer having a crosslinking functional group for improving the film hardness of an image area in the main chain or a side chain, preferably, in a side chain as described in JP2008-195018A is exemplified. The crosslinking group forms a crosslink between polymer molecules, and curing is accelerated.

As the crosslinking functional group, ethylenically unsaturated groups such as a (meth)acrylic group, a vinyl group, an allyl group, or a styryl group, an epoxy group, and the like are preferred, and the crosslinking functional group can be introduced to the polymer by a polymer reaction or copolymerization. For example, a reaction between an acrylic polymer or polyurethane having a carboxy group in a side chain and glycidyl methacrylate or a reaction between a polymer having an epoxy group and an ethylenically unsaturated group-containing carboxylic acid such as a methacrylic acid can be used.

The content of the crosslinking group in the binder polymer is preferably 0.1 mmol to 10.0 mmol, more preferably 0.25 mmol to 7.0 mmol, and particularly preferably 0.5 mmol to 5.5 mmol per gram of the binder polymer.

In addition, the binder polymer preferably has a hydrophilic group. The hydrophilic group contributes to the impartation of on-machine developability to the image-recording layer. Particularly, in a case in which the crosslinking group and the hydrophilic group coexist, printing resistance is excellent.

Examples of the hydrophilic group include a hydroxy group, a carboxy group, an alkylene oxide structure, an amino group, an ammonium group, an amide group, a sulfo group, a phosphate group, and the like, and, among these, an alkylene oxide structure having one to nine alkylene oxide units having 2 or 3 carbon atoms is preferred. The hydrophilic group can be imparted to the binder polymer by, for example, copolymerizing monomers having a hydrophilic group.

In order to control an ink-absorbing property, it is also possible to introduce a lipophilic group such as an alkyl group, an aryl group, an aralkyl group, or an alkenyl group to the binder polymer. A lipophilic group can be introduced to the binder polymer by, for example, copolymerizing lipophilic group-containing monomers such as a methacrylic acid alkyl ester.

The weight-average molecular weight (Mw) of the binder polymer is preferably 2,000 or more, more preferably 5,000 or more, and still more preferably 10,000 to 300,000.

Only one binder polymer may be used or two or more binder polymers may be jointly used.

The content of the binder polymer is preferably 3% by mass to 90% by mass, more preferably 5% by mass to 80% by mass, and still more preferably 10% by mass to 70% by mass of the total mass of the image-recording layer.

### «Particulate polymer compound»

The particulate polymer compound is preferably selected from the group consisting of a hydrophobic thermoplastic resin particle, a thermally reactive resin particle, a resin particle having a polymerizable group, a microcapsule including a hydrophobic compound, and a micro gel (crosslinking resin particle). Among these, a resin particle having a polymerizable group or a micro gel is preferred. In a particularly preferred embodiment, the particulate polymer compound has at least one ethylenically unsaturated group. From the presence of the above-described particulate polymer compound, an effect for enhancing the printing resistance of an exposed portion is obtained.

The hydrophobic thermoplastic resin particle is preferably a hydrophobic thermoplastic resin particle described in Research Disclosure No. 33303 of January 1992 and the specifications of JP1997-123387A (JP-H09-123387A), JP1997-131850A (JP-H09-131850A), JP1997-171249A(JP-H09-171249A), JP1997-171250A (JP-H09-171250A), and EP931647B.

As specific examples of a polymer that constitutes the hydrophobic thermoplastic resin particle, homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and the like and mixtures thereof can be exemplified. Preferably, copolymers having polystyrene, styrene, and acrylonitrile and polymethyl methacrylate can be exemplified. The average particle diameter of the hydrophobic thermoplastic resin particles is preferably in a range of 0.01 µm to 3.0 µm.

As the thermally reactive resin particle, a resin particle having a thermally reactive group is exemplified. The thermally reactive resin particle forms a hydrophobilized region through crosslinking by a thermal reaction and a change in a functional group at this time.

The thermally reactive group in the resin particle having a thermally reactive group may be a functional group that causes any reaction as long as a chemical bond is formed, but is preferably a polymerizable group, and preferred examples thereof include ethylenically unsaturated groups that cause radical polymerization reactions (for example, acryloyl groups, methacryloyl groups, vinyl groups, allyl groups, and the like), cationic polymerizable groups (for example, vinyl groups, vinyloxy groups, epoxy groups, oxetanyl groups, and the like), isocyanato groups that cause addition reactions or blocked bodies thereof, epoxy groups, vinyloxy groups, functional groups having active hydrogen atoms that are reaction partners thereof (for example, amino groups, hydroxy groups, carboxy groups, and the like), carboxy groups that cause condensation reactions, hydroxy groups or amino groups that are reaction partners, acid anhydrides that cause ring-opening addition reactions, amino groups or hydroxy groups which are reaction partners, and the like.

Examples of the microcapsules include microcapsules including at least some of the constituent components of the image-recording layer as described in JP2001-277740A and JP2001-277742A. The constituent components of the image-recording layer can also be added outside the microcapsules. A preferred aspect of the image-recording layer including the microcapsules is an image-recording layer including hydrophobic constituent components in the microcapsules and including hydrophilic constituent components outside the microcapsules.

Micro gels (crosslinking resin particles) are capable of containing some of the constituent components of the image-recording layer in at least one of the surface or inside thereof. Particularly, reactive micro gels having radical polymerizable groups on the surface are preferred from the viewpoint of image-recording sensitivity or printing resistance.

In order to put the constituent components of the image-recording layer into microcapsules or micro gels, well-known methods can be applied.

The average particle diameter of the particulate polymer compound is preferably in a range of 0.01 µm to 3.0 µm, more preferably in a range of 0.03 µm to 2.0 µm, and still more preferably in a range of 0.10 µm to 1.0 µm. Within this range, favorable resolution and temporal stability can be obtained.

Only one particulate polymer compound may be used or two or more particulate polymer compounds may be jointly used.

The content of the particulate polymer compound is preferably 5% by mass to 90% by mass of the total mass of the image-recording layer.

### <Thermoplastic resin particle>

The glass transition temperature (Tg) of the thermoplastic resin particle is preferably 60°C to 250°C. Tg of the thermoplastic resin particle is more preferably 70°C to 140°C and still more preferably 80°C to 120°C.

The thermoplastic resin particle having Tg of 60°C or higher is not particularly limited; however, among the above-described hydrophobic thermoplastic resin particles, hydrophobic thermoplastic resin particles in which Tg of the resin is 60°C or higher can be preferably exemplified.

The average particle diameter of the thermoplastic resin particle is preferably 0.005 µm to 2.0 µm, more preferably 0.01 µm to 1.5 µm, and particularly preferably 0.05 µm to 1.0 µm.

In a case in which two or more kinds of thermoplastic resin particles are mixed together, the polydispersity is preferably 0.2 or more.

Meanwhile, the average particle diameter and the polydispersity of the thermoplastic resin particle and the like in the present disclosure are computed by laser light scattering.

Two or more kinds of thermoplastic resin particles may be used in a mixture form. Specifically, the use of at least two kinds of thermoplastic resin particles having different particle sizes or the use of at least two kinds of thermoplastic resin particles having different Tg's is exemplified. The use of two or more kinds of thermoplastic resin particles in a mixture form further improves the film-curing property of the image area and further improves printing resistance in a case in which lithographic printing plates are produced.

In a case in which two or more kinds of thermoplastic resin particles having different Tg's are used in a mixture form, Tg of at least one kind of the thermoplastic resin particle is preferably 60°C or higher. At this time, the difference in Tg is preferably 10°C or higher and more preferably 20°C or higher. In addition, the content of the thermoplastic resin particle having Tg of 60°C or higher is preferably 70% by mass or more of all of the thermoplastic resin particles.

The thermoplastic resin particle may have a crosslinking group. In the case of using a thermoplastic fine particle polymer having a crosslinking group, the crosslinking group thermally reacts due to heat that is generated in an image-exposed portion and forms a crosslink between polymers, the film hardness of the image area improves, and the printing resistance becomes superior. The crosslinking group may be a functional group carrying out any reaction as long as a chemical bond is formed, and, for example, ethylenically unsaturated groups carrying out a polymerization reaction (for example, an acryloyl group, a methacryloyl group, a vinyl group, an allyl group, and the like), isocyanate groups carrying out an addition reaction, blocked bodies thereof, groups having an active hydrogen atom that is a reaction partner thereof (for example, an amino group, a hydroxy group, a carboxy group, and the like), epoxy groups, similarly, carrying out an addition reaction, amino groups, carboxy groups, or hydroxy groups that are a reaction partner thereof, carboxy groups carrying out a condensation reaction and hydroxy groups or amino groups, acid anhydrides carrying out a ring-opening addition reaction and amino groups or hydroxy groups, and the like can be exemplified.

As the thermoplastic resin particle having a crosslinking group, specifically, groups having a crosslinking group such as an acryloyl group, a methacryloyl group, a vinyl group, an allyl group, an epoxy group, an amino group, a hydroxy group, a carboxy group, an isocyanate group, an acid anhydride, and groups that protect the above-described groups can be exemplified. These crosslinking groups may be introduced into the polymer during the polymerization of the resin or by using a polymer reaction after the polymerization of the resin.

In the case of introducing the crosslinking group during the polymerization of the resin, a monomer having the crosslinking group is preferably emulsification-polymerized or suspension-polymerized. As specific examples of the monomer having the crosslinking group, allyl methacrylate, allyl acrylate, vinyl methacrylate, vinyl acrylate, glycidyl methacrylate, glycidyl acrylate, blocked isocyanates by 2-isocyanate ethyl methacrylate or an alcohol thereof, blocked isocyanates by 2-isocyanate ethyl acrylate or an alcohol thereof, 2-aminoethyl methacrylate, 2-aminoethyl acrylate, 2-hydroxyethyl methacrylate, 2-hydroxyethyl acrylate, acrylic acid, methacrylic acid, maleic anhydride, bifunctional acrylate, bifunctional methacrylate, and the like can be exemplified.

As the polymer reaction that is used in the case of introducing the crosslinking group after the polymerization of the resin, for example, a polymer reaction described in WO96/034316A can be exemplified.

The thermoplastic resin particles may react with each other through the crosslinking group and may react with a polymer compound or a low-molecular-weight compound added to the image-recording layer.

The content of the thermoplastic resin particle is preferably 50% by mass to 95% by mass, more preferably 60% by mass to 90% by mass, and particularly preferably 70% by mass to 85% by mass of the total mass of the image-recording layer.

### «Other components»

The image-recording layer may further contain, as other components, a low-molecular-weight hydrophilic compound, a sensitization agent, a surfactant, a coloring agent, a print-out agent, a polymerization inhibitor, a higher-fatty acid derivative, a plasticizer, inorganic particles, an inorganic lamellar compound, a co-sensitizer, a chain transfer agent, or the like. Specifically, it is possible to preferably use compounds and amounts added described in Paragraphs 0171 to 0177 of JP2015-108141A, Paragraphs 0114 to 0159 of JP2008-284817A, Paragraphs 0023 to 0027 of JP2006-091479A, Paragraph 0060 of the specification of US2008/0311520A, and Paragraphs 0152 to 0168 and 0202 to 0222 of WO2015/054145A.

### <Exposure step>

The method for producing a lithographic printing plate according to the embodiment of the present disclosure includes a step of exposing the lithographic printing plate precursor in an image shape.

In the exposure step, the lithographic printing plate precursor is exposed through a transparent original image having a linear image, a halftone image, and the like or exposed by laser scanning using digital data, thereby being exposed in an image shape. As exposure light sources, for example, a carbon arc, a high-pressure mercury lamp, a xenon lamp, a metal halide lamp, a fluorescent lamp, a tungsten lamp, a halogen lamp, an ultraviolet laser, a visible light laser, and an infrared laser are exemplified. In particular, a laser is preferred, and a semiconductor laser that radiates light having a wavelength in a range of 250 nm to 420 nm, a solid-state laser and a semiconductor layer which radiate infrared rays having a wavelength in a range of 760 nm to 1,200 nm, and the like are exemplified. In the case of using a laser, the lithographic printing plate precursor is preferably exposed by laser scanning in an image shape according to digital data. In addition, in order to shorten the exposure time, it is preferable to use a multi-beam laser device.

These lasers are used by being mounted in a so-called platesetter in which exposure is carried out in an image shape by computer control.

In the present disclosure, a development process may be carried out immediately after the exposure step, but it is also possible to provide a heating process step (preheating) between the exposure step and the development step. This heating process has an effect of improving the printing resistance and, furthermore, increasing the uniformity of the degree of image curing in the plate surface, and a condition thereof can be appropriately set as long as the effect can be exhibited. As heating means, a convection oven, an infrared (IR) radiator, an IR laser, a microwave device, a Wisconsin oven, and the like, which are all conventional means, can be exemplified. Specifically, the lithographic printing plate precursor can be heated by holding the lithographic printing plate precursor at a plate surface peak temperature in a range of 70°C to 150°C for one second to five minutes, preferably 80°C to 140°C for five seconds to one minute, and more preferably, at 90°C to 130°C for 10 to 30 seconds. Within this range, the above-described effect can be efficiently obtained, and there is no adverse influence such as the deformation of a printing plate by heat, which is preferable.

At this time, it is preferable that heating process means that is used in the heating process step and a developing machine that is used in the development process step are connected to each other and the lithographic printing plate precursor is automatically and continuously processed. A specific example thereof is a plate-making line in which a platesetter and a developing machine are connected to each other using transportation means such as a conveyor. The heating process means may be provided between the platesetter and the developing machine, and the heating means and the developing machine may be integrated together to be a single device.

In a case in which a printing plate being used is likely to be affected by ambient light in an operation environment, the above-described plate-making line is preferably shielded from light using a filter, a cover, or the like. In addition, in a case in which the heating process is not carried out, it is preferable that the exposure means is directly connected to the development process means that is constituted to carry out the development process and the processes are carried out automatically and continuously.

In addition, in the present disclosure, the development process may be carried out immediately after the exposure step, but a water washing step (pre-water washing) may be provided between the exposure step and the removal step for the purpose of the removal of the protective layer or the like.

Any one or both of the above-described two steps may be provided.

In addition, after the end of the development process described below and the formation of an image, the entire surface may be exposed to active light rays such as ultraviolet rays and the curing of the image area may be accelerated. As a light source for the exposure of the entire surface, for example, a carbon arc lamp, a mercury lamp, a gallium lamp, a metal halide lamp, a xenon lamp, a tungsten lamp, a variety of laser lights, and the like are exemplified. Furthermore, in order to obtain sufficient printing resistance, the full surface exposure amount is preferably at least 10 mJ/cm² or more and more preferably 100 mJ/cm² or more.

Furthermore, the lithographic printing plate precursor may be heated at the same time as the exposure of the entire surface, and the heating enables the printing resistance to further improve. As a heating device, a convection oven, an IR radiator, an IR laser, a microwave device, a Wisconsin oven, and the like, which are all conventional means, can be exemplified. The plate surface temperature at this time is preferably 30°C to 150°C, more preferably 35°C to 130°C, and still more preferably 40°C to 120°C.

In the present disclosure, in order to facilitate the upcoming handling, the lithographic printing plate precursor on which the development process and, additionally, the processes by preheating and the pre-water washing step have been carried out and in which an image has been formed is preferably dried. As a drying method, methods such as natural drying in which the lithographic printing plate precursor is left to stand indoors, hot-air drying, the use of a dryer attached to a gum coater or an automatic developing machine are exemplified.

### <Removal step>

The method for producing a lithographic printing plate according to the embodiment of the present disclosure includes a step of removing a non-exposed portion of the exposed image-recording layer in the lithographic printing plate precursor using a developer (hereinafter, also referred to as "development process step"), the developer includes a compound having at least one acidic group selected from the group consisting of a phosphate group, a phosphonate group, and a phosphinate group and one or more carboxy groups, and the pH of the developer is 5 to 10.

### - Developer -

In the method for producing a lithographic printing plate according to the embodiment of the present disclosure, a developer having a pH of 5 to 10 and including a compound having at least one acidic group selected from the group consisting of a phosphate group, a phosphonate group, and a phosphinate group and one or more carboxy groups is used.

Hereinafter, the details of the respective components of the developer will be described.

### «Specific compound»

The developer that is used in the present disclosure includes a compound (specific compound) having at least one acidic group selected from the group consisting of a phosphate group, a phosphonate group, and a phosphinate group and one or more carboxy groups.

It is considered that the specific compound has at least one acidic group selected from the group consisting of a phosphate group, a phosphonate group, and a phosphinate group that are adsorptive to the hydrophilic support and, furthermore, a hydrophilic carboxy group, whereby the surface of the lithographic printing plate is hydrophilized and a stain property, particularly, scratch stain resistance improves.

The specific compound preferably has a phosphate group or a phosphonate group.

The phosphate group, the phosphonate group, the phosphinate group, and the carboxy group in the specific compound may form a salt not only with a monovalent metal ion such as a potassium ion or a sodium ion but also with a divalent metal ion such as a calcium ion or a magnesium ion, an ammonium ion, or the like.

The total number of the phosphate groups, the phosphonate groups, and the phosphinate groups in the specific compound is preferably 1 or more and 4 or less, more preferably 1 or more and 3 or less, still more preferably 1 or 2, and particularly preferably one 1 the viewpoint of scratch stain resistance.

The total number of the carboxy groups in the specific compound is preferably 1 or more and 10 or less, more preferably 2 or more and 10 or less, still more preferably 3 or more and 6 or less, and particularly preferably 3 or 4 from the viewpoint of scratch stain resistance.

The total number of carbon atoms in the specific compound is preferably 3 or more and 50 or less, more preferably 3 or more and 20 or less, still more preferably 4 or more and 12 or less, and particularly preferably 5 or more and 10 or less from the viewpoint of scratch stain resistance.

In addition, in the specific compound, a portion other than the phosphate group, the phosphonate group, the phosphinate group, and the carboxy group preferably includes a carbon atom, a hydrogen atom, and, as necessary, an oxygen atom.

The specific compound may be used singly or two or more specific compounds may be jointly used.

The content of the specific compound is preferably 0.1% by mass to 10% by mass, more preferably 0.3% by mass to 8% by mass, and particularly preferably 0.5% by mass to 6% by mass of the total mass of the developer. Within the above-described range, the scratch stain resistance is superior, and the ink-absorbing property of lithographic printing plates to be obtained is excellent.

The molecular weight of the specific compound is preferably 1,000 or less, more preferably 600 or less, and particularly preferably 150 or more and 500 or less. Within the above-described range, the viscosity of the developer is appropriate, and, in the case of using an automatic developing machine, it is possible to suppress the deposition of a component of the developer on a roller of the automatic developing machine and suppress roller stains.

As preferred specific examples of the specific compound, for example, compounds illustrated below are exemplified.

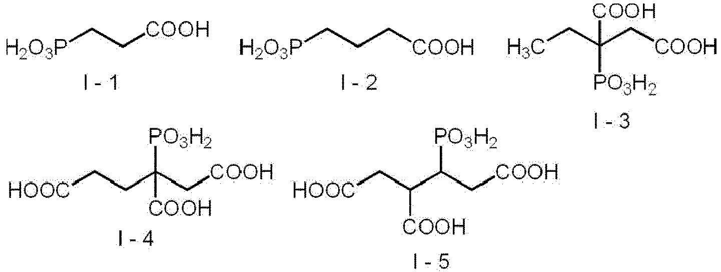

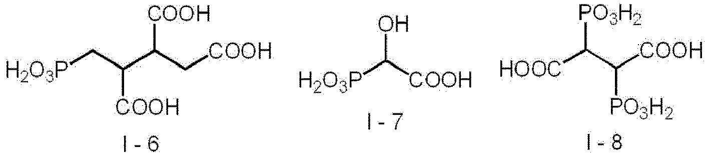

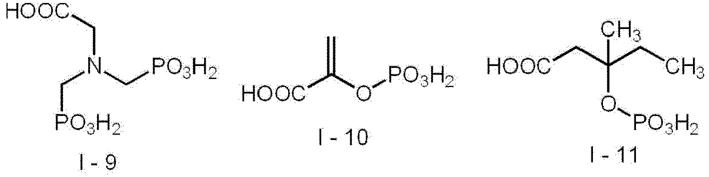

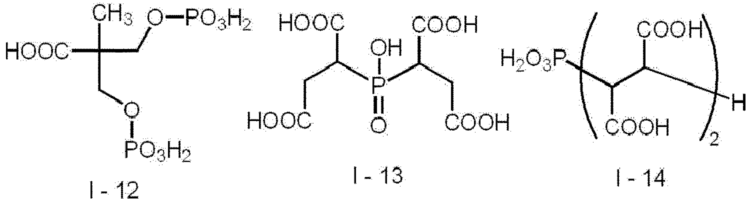

### «Surfactant»

The developer that is used in the present disclosure may contain a surfactant such as an anionic surfactant, a nonionic surfactant, a cationic surfactant, or a betine surfactant.

Among these, from the viewpoint of scratch stain resistance and an ink-absorbing property, the developer preferably includes at least one selected from the group consisting of an anionic surfactant and a nonionic surfactant and more preferably includes an anionic surfactant and a nonionic surfactant.

As the anionic surfactant, a compound represented by Formula (I) is preferably exemplified.

R¹-Y¹-X¹ (I)

In Formula (I), R¹ represents an alkyl group, a cycloalkyl group, an alkenyl group, an aralkyl group, or an aryl group which may have a substituent.

As the alkyl group, for example, an alkyl group having 1 to 20 carbon atoms is preferred, and, specifically, a methyl group, an ethyl group, a propyl group, an n-butyl group, a sec-butyl group, a hexyl group, a 2-ethylhexyl group, an octyl group, a decyl group, a dodecyl group, a hexadecyl group, a stearyl group, and the like can be preferably exemplified.

The cycloalkyl group may be a monocyclic cycloalkyl group or a polycyclic cycloalkyl group. As the monocyclic cycloalkyl group, a monocyclic cycloalkyl group having 3 to 8 carbon atoms is preferred, and a cyclopropyl group, a cyclopentyl group, a cyclohexyl group, or a cyclooctyl group is more preferred. As the polycyclic cycloalkyl group, for example, an adamantyl group, a norbornyl group, an isobornyl group, a camphanyl group, a dicyclopentyl group, an α-pinel group, a tricyclodecanyl group, and the like can be preferably exemplified.

As the alkenyl group, for example, an alkenyl group having 2 to 20 carbon atoms is preferred, and, specifically, a vinyl group, an allyl group, a butenyl group, a cyclohexenyl group, and the like can be preferably exemplified.

As the aralkyl group, for example, an aralkyl group having 7 to 12 carbon atoms is preferred, and, specifically, a benzyl group, a phenethyl group, a naphthylmethyl group, and the like can be preferably exemplified.

As the aryl group, for example, an aryl group having 6 to 15 carbon atoms is preferred, and, specifically, a phenyl group, a tolyl group, a dimethylphenyl group, a 2,4,6-trimethylphenyl group, a naphthyl group, an anthryl group, a 9,10-dimethoxyanthryl group, and the like can be preferably exemplified.

In addition, as the substituent, monovalent non-metal atomic groups excluding a hydrogen atom are used, and preferred examples thereof include a halogen atom (F, Cl, Br, or I), a hydroxy group, an alkoxy group, an aryloxy group, an acyl group, an amide group, an ester group, an acyloxy group, a carboxy group, a carboxylic acid anion group, a sulfonic acid anion group, and the like.

As specific examples of the alkoxy group in these substituent, alkoxy groups preferably having 1 to 40 carbon atoms and more preferably having 1 to 20 carbon atoms such as a methoxy group, an ethoxy group, a propyloxy group, an isopropyloxy group, a butyloxy group, a pentyloxy group, a hexyloxy group, a dodecyloxy group, a stearyloxy group, a methoxyethoxy group, a poly(ethyleneoxy) group, and a poly(propyleneoxy) group are exemplified. As the aryloxy group, aryloxy groups having 6 to 18 carbon atoms such as a phenoxy group, a tolyloxy group, a xylyloxy group, a mesityloxy group, a cumenyl oxy group, a methoxyphenyloxy group, an ethoxyphenyloxy group, a chlorophenyloxy group, a bromophenyloxy group, and a naphthyloxy group are exemplified. As the acyl group, acyl groups having 2 to 24 carbon atoms such as an acetyl group, a propanoyl group, a butanoyl group, a benzoyl group, and a naphthoyl group are exemplified. As the amide group, amide groups having 2 to 24 carbon atoms such as an acetamide group, a propionic acid amide group, a dodecanoic acid amide group, a palmitic acid amide group, a stearic acid amide group, a benzoic acid amide group, and a naphthoic acid amide group are exemplified. As the acyloxy group, acyloxy groups having 2 to 20 carbon atoms such as an acetoxy group, a propanoyloxy group, a benzoyloxy group, and a naphthoyloxy group are exemplified. As the ester group, ester groups having 1 to 24 carbon atoms such as a methyl ester group, an ethyl ester group, a propyl ester group, a hexyl ester group, an octyl ester group, a dodecyl ester group, and a stearyl ester group are exemplified. The substituent may be a substituent formed of a combination of two or more substituents described above.

X¹ represents a sulfonate group, a sulfuric acid monoester salt group, a carboxylate group, or a phosphate group.

Y¹ represents a single bond, -CnH2n-, -Cₙ₋ₘH₂₍ₙ₋ₘ₎OCₘH₂ₘ-, -O-(CH₂CH₂O)ₙ-, -O-(CH₂CH₂CH₂O)ₙ-, -CO-NH-, or a divalent linking group formed of a combination of two or more thereof and satisfies n≥1 and n≥m≥0.

Among these, among compounds represented by Formula (I), a compound represented by Formula (I-A) or (I-B) is preferred from the viewpoint of scratch stain resistance.

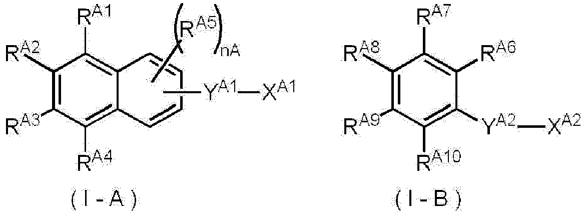

In Formula (I-A) and Formula (I-B),R^{A1} to R^{A10} each independently represent a hydrogen atom or an alkyl group, nA represents an integer of 1 to 3, X^{A1} and X^{A2} each independently represents a sulfonate group, a sulfuric acid monoester salt group, a carboxylate group, or a phosphate group, Y^{A1} and Y^{A2} each independently represents a single bond, -CₙH₂ₙ-, -Cₙ₋ₘH₂(ₙ₋ₘ)OCₘH₂ₘ-, -O-(CH₂CH₂O)ₙ-, -O-(CH₂CH₂CH₂O)ₙ-, -CO-NH-, or a divalent linking group formed of a combination of two or more thereof and satisfies n≥1 and n≥m≥0, and the total of the numbers of the carbon atoms in R^{A1} to R^{A5} or R^{A6} to R^{A10} and Y^{A1} or Y^{A2} is three or more.

In the compound represented by Formula (I-A) or Formula (I-B), the total number of carbon atoms in R^{A1} to R^{A5} and Y^{1A} or R^{A6} to R^{A10} and Y^{A2} is preferably 25 or less and more preferably 4 to 20. The structure of the above-described alkyl group may be linear or branched.

X^{A1} and X^{A2} in the compound represented by Formula (I-A) or Formula (I-B) are preferably a sulfonate group or a carboxylate group. In addition, the salt structure in X^{A1} and X^{A2} is preferably an alkali metal salt since the alkali metal salt has a favorable solubility particularly in water-based solvents. Among them, a sodium salt or a potassium salt is particularly preferred.

In addition, regarding the compound represented by Formula (I-A) or Formula (I-B), it is possible to refer to the description of Paragraphs 0019 to 0037 of JP2007-206348A.

Furthermore, as the anionic surfactant, it is possible to preferably use compounds described in Paragraphs 0023 to 0028 of JP2006-065321A.

In addition, as nonionic surfactant, polyoxyethylene alkyl ethers, polyoxyethylene alkyl phenyl ethers, polyoxyethylene polystyryl phenyl ether, glycerin aliphatic acid partial esters, sorbitan aliphatic acid partial esters, pentaerythritol aliphatic acid partial esters, propylene glycol mono aliphatic acid ester, sucrose aliphatic acid partial ester, polyoxyethylene sorbitan aliphatic acid partial esters, polyoxyethylene sorbitol aliphatic acid partial esters, polyethylene glycol aliphatic acid esters, polyglycerin aliphatic acid partial esters, polyoxyethylene glycerin aliphatic acid partial esters, polyoxyethylene diglycerins, aliphatic acid diethanolamides, N,N-bis-2-hydroxyalkylamines, polyoxyethylene alkylamine, triethanolamine aliphatic acid ester, trialkylamine oxide, polyoxyethylene alkyl phenyl ethers, polyoxyethylene-polyoxypropylene blocked copolymers, and the like are exemplified.

In addition, acetylene glycol-based and acetylene alcohol-based oxyethylene adducts and fluorine-based and other surfactants can also be used in the same manner. Two or more surfactants described above can be jointly used.

As the nonionic surfactant, a nonionic aromatic ether-based surfactant represented by Formula (N1) is particularly preferably exemplified.

X^{N}-Y^{N}-O-(A¹)_{nB}-(A²)_{mB}-H (N1)

In the formula, X^{N} represents an aromatic group that may have a substituent, Y^{N} represents a single bond or an alkylene group having 1 to 10 carbon atoms, A¹ and A² are mutually different groups and are represented by any of -CH₂CH₂O- or -CH₂CH(CH₃)O-, nB and mB each independently represent an integer of 0 to 100; here, nB and mB are not zero at the same time, and, in a case in which any of nB or mB is zero, nB and mB are not one.

In the formula, as the aromatic group as X^{N}, a phenyl group, a naphthyl group, an anthranyl group, and the like are exemplified. These aromatic groups may have a substituent. As the substituent, organic groups having 1 to 100 carbon atoms are exemplified. Meanwhile, in the formula, in a case in which both A and B are present, the surfactant may be a random or blocked copolymer.

As specific examples of the organic group having 1 to 100 carbon atoms, aliphatic hydrocarbon groups and aromatic hydrocarbon groups which may be saturated or unsaturated and may be linear or branched, for example, an alkyl group, an alkenyl group, an alkynyl group, an aryl group, an aralkyl group, and the like, additionally, an alkoxy group, an aryloxy group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an acylamino group, an N-alkylacylamino group, an N-arylacylamino group, an acyl group, an alkoxycarbonylamino group, an alkoxycarbonyl group, an aryloxycarbonyl group, a carbamoyl group, an N-alkylcarbamoyl group, an N,N-dialkylcarbamoyl group, an N-arylcarbamoyl group an N,N-diarylcarbamoyl group, an N-alkyl-N-arylcarbamoyl group, a polyoxyalkylene chain, the above-described organic groups to which a polyoxyalkylene chain bonds, and the like. The alkyl group may be linear or branched.

In addition, as the nonionic surfactant, it is possible to preferably use compounds described in Paragraphs 0030 to 0040 of JP2006-065321A.

The surfactant may be used singly or two or more surfactants may be jointly used.

The content of the surfactant is preferably 1% by mass to 25% by mass, more preferably 2% by mass to 20% by mass, still more preferably 3% by mass to 15% by mass, and particularly preferably 5% by mass to 10% by mass of the total mass of the developer. In a case in which the content of the surfactant is in the above-described range, the scratch stain resistance is superior, the dispersibility of development scum is excellent, and the ink-absorbing property of lithographic printing plates to be obtained is excellent.

In addition, in the case of jointly using the nonionic surfactant and the anionic surfactant, the content of the nonionic surfactant is preferably larger than the content of the anionic surfactant. In the above-described aspect, the developability is excellent, and the scratch stain resistance is superior.

Furthermore, in the case of jointly using the nonionic surfactant and the anionic surfactant, from the viewpoint of developability and scratch stain resistance, the mass ratio (the nonionic surfactant/the anionic surfactant) of the content of the nonionic surfactant to the content of the anionic surfactant in the developer is preferably 1.2:1.0 to 5.0:1.0, more preferably 1.5:1.0 to 4.0:1.0, and particularly preferably 2.0:1.0 to 3.0:1.0.

### «Water-soluble polymer compound»

From the viewpoint of adjusting the viscosity of the developer and protecting the plate surface of a lithographic printing plate to be obtained, the developer that is used in the present disclosure may include a water-soluble polymer.

As a water-soluble polymer, the developer may contain a water-soluble polymer compound such as a soy polysaccharide, modified starch, gum arabic, dextrin, a fibrin derivative (for example, carboxymethyl cellulose, carboxyethyl cellulose, methyl cellulose, or the like) and a modified product thereof, pullulan, polyvinyl alcohol and a derivative thereof, polyvinyl pyrrolidone, polyacrylamide and an acrylamide copolymer, a vinyl methyl ether/maleic anhydride copolymer, a vinyl acetate/maleic anhydride copolymer, or a styrene/maleic anhydride copolymer.

As the soy polysaccharide, soy polysaccharides known in the related art can be used, and, for example, as commercially available products, there is SOYAFIBE (trade name, manufactured by Fuji Oil Co., Ltd.), and it is possible to use a variety of grades of soy polysaccharides. Soy polysaccharides that can be preferably used have a viscosity of a 10% by mass aqueous solution in a range of 10 mPa/sec to 100 mPa/sec.

As the modified starch, starch represented by Formula (III) is preferred. As the starch represented by Formula (III), any starch such as corn, potato, tapioca, rice, or wheat can be used. The starch can be modified using a method in which starch is decomposed using an acid, an enzyme, or the like to the number of glucose residues per molecule in a range of 5 to 30 and, furthermore, oxypropylene is added thereto in an alkali.

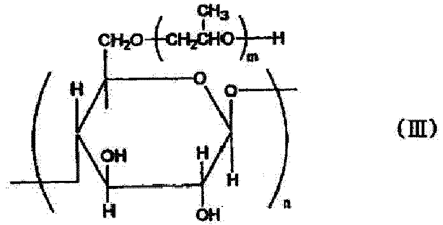

In the formula, the degree of etherification (degree of substitution) is in a range of 0.05 to 1.2 per glucose unit, n represents an integer of 3 to 30, and m represents an integer of 1 to 3.

Among the water-soluble polymer compounds, soy polysaccharides, modified starch, gum Arabic, dextrin, carboxymethyl cellulose, polyvinyl alcohol, and the like are particularly preferred.

Two or more water-soluble polymer compounds can be jointly used.

The developer preferably contains no water-soluble polymer compound or contains a water-soluble polymer compound in a content of more than 0% by mass and 1% by mass or less of the total mass of the developer, more preferably contains no water-soluble polymer compound or contains a water-soluble polymer compound in a content of more than 0% by mass and 0.1% by mass or less of the total mass of the developer, still more preferably contains no water-soluble polymer compound or contains a water-soluble polymer compound in a content of more than 0% by mass and 0.05% by mass or less of the total mass of the developer, and particularly preferably contains no water-soluble polymer compound. In the above-described aspect, the viscosity of the developer is appropriate, and it is possible to suppress the deposition of development scum or the like in a roller member such as an automatic developing machine.

### «Other additives»

The developer that is used in the present disclosure may contain, in addition to the above-described components, a wetting agent, a preservative, a chelate compound, a defoamer, an organic acid, an organic solvent, an inorganic acid, an inorganic salt, or the like.

As the wetting agent, ethylene glycol, propylene glycol, triethylene glycol, butylene glycol, hexylene glycol, diethylene glycol, dipropylene glycol, glycerin, trimethylolpropane, diglycerin, and the like are preferably used. These wetting agents may be used singly or two or more wetting agents may be jointly used. The content of the wetting agent is preferably 0.1% by mass to 5% by mass of the total mass of the developer.

As the preservative, phenol or a derivative thereof, formalin, an imidazole derivative, sodium dehydroacetate, a 4-isothiazolin-3-one derivative, benzisothiazolin-3-one, 2-methyl-4-isothiazolin-3-one, a benzotriazole derivative, an amidine guanidine derivative, a quaternary ammonium salt, a derivative of pyridine, quinoline, guanidine, or the like, diazine, a triazole derivative, oxazole, an oxazine derivative, nitrobromo alcohol-based 2-bromo-2-nitropropane-1,3-diol, 1,1-dibromo-1-nitro-2-ethanol, 1,1-dibromo-1-nitro-2-propanol, or the like can be preferably used.

The amount of the preservative added needs to be an amount in which the preservative stably exhibits an effect with respect to bacteria, fungi, yeast, and the like and which varies depending on the kind of bacteria, fungi, and yeast and is preferably in a range of 0.01% by mass to 4% by mass of the total mass of the developer. In addition, two or more preservatives are preferably jointly used so as to be effective to a variety of fungi and bacteria.

As the chelate compound, for example, ethylenediaminetetraacetic acid, potassium salts thereof, and sodium salts thereof; diethylenetriaminepentaacetic acid, potassium salts thereof, and sodium salts thereof; triethylenetetraminehexaacetic acid, potassium salts thereof, and sodium salts thereof; hydroxyethylethylenediaminetriacetic acid, potassium salts thereof, and sodium salts thereof; nitrilotriacetic acid, and sodium salts thereof; 1-hydroxyethane-1,1-diphosphonic acid, potassium salts thereof, and sodium salts thereof; and organic phosphonic acids such as aminotri(methylene phosphonate), potassium salts thereof, and sodium salts thereof can be exemplified. Instead of sodium salts and potassium salts of the chelating agents, salts of organic amines are also effective.

The chelating agent is preferably a chelating agent that is stably present in a process liquid composition and does not impair a printing property. The content of the chelating agent is preferably 0.001% by mass to 1.0% by mass of the total mass of the developer.

As the defoamer, it is possible to use an ordinary silicone-based self-emulsification-type, emulsification-type, or nonionic compound having a hydrophilic-lipophilic balance (HLB) of 5 or less. A silicone defoamer is preferred.

Meanwhile, in the present disclosure, a silicone-based surfactant is regarded as the defoamer.

The content of the defoamer is preferably in a range of 0.001% by mass to 1.0% by mass of the total mass of the developer.

As the organic acid, citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, organic phosphonic acid, and the like are exemplified. The organic acid can also be used in a form of an alkali metal salt or ammonium salt thereof. The content of the organic acid is preferably 0.01% by mass to 0.5% by mass of the total mass of the developer.

As the organic solvent that can be contained, for example, aliphatic hydrocarbons (hexane, heptane, "ISOPAR E, H, G" (manufactured by Esso Chemical Co., Ltd.), gasoline, kerosene, and the like), aromatic hydrocarbons (toluene, xylene, and the like), halogenated hydrocarbons (methylene dichloride, ethylene dichloride, trichloroethylene, monochlorobenzene, and the like), polar solvents, and the like are exemplified.

As the polar solvents, alcohols (methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol, methyl amyl alcohol, and the like), ketones (acetone, methyl ethyl ketone, ethyl butyl ketone, methyl isobutyl ketone, cyclohexanone, and the like), esters (ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, butyl levulinate, and the like), other polar solvents (triethyl phosphate, tricresyl phosphate, N-phenylethanolamine, N-phenyldiethanolamine, and the like), and the like are exemplified.

In addition, in a case in which the organic solvent is not soluble in water, it is also possible to make the organic solvent soluble in water using a surfactant or the like and then use the organic solvent, and, in a case in which the developer contains the organic solvent, from the viewpoint of safety and inflammability, the concentration of the solvent in the developer is preferably less than 40% by mass.

As the inorganic acid and the inorganic salt, phosphoric acid, metaphosphoric acid, primary ammonium phosphate, secondary ammonium phosphate, primary sodium phosphate, secondary sodium phosphate, primary potassium phosphate, secondary potassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, nickel sulfate, and the like are exemplified. The content of the inorganic salt is preferably 0.01% by mass to 0.5% by mass of the total mass of the developer.

The developer that is used in the present disclosure is obtained by dissolving or dispersing the respective components described above in water as necessary. The concentration of the solid content of the developer is preferably 2% by mass to 25% by mass. In addition, as the developer, it is also possible to produce a concentrated liquid and, at the time of being used, dilute the concentrated liquid with water.

In addition, the developer that is used in the present disclosure is preferably an aqueous developer.

The pH of the developer that is used in the present disclosure is 5 to 10, preferably 6 to 9, and more preferably 7 to 9. From the viewpoint of developability and the dispersibility of the image-recording layer, it is advantageous to set the value of pH to be high; however, regarding a printing property, particularly, stain, it is advantageous to set the value of pH to be low.

In addition, from the viewpoint of the dispersibility of development scum, the developer that is used in the present disclosure preferably contains an alcohol compound.

As the alcohol compound, methanol, ethanol, propanol, isopropanol, benzyl alcohol, and the like are exemplified. Among these, benzyl alcohol is preferred.

The content of the alcohol compound is preferably 0.01% by mass to 5% by mass, more preferably 0.1% by mass to 2% by mass, and particularly preferably 0.2% by mass to 1% by mass of the total mass of the developer from the viewpoint of the dispersibility of development scum.

### - Development process method -

In the removal step (development process step), in the case of a manual process, as a development process method, for example, a method in which an aqueous solution is sufficiently soaked into a sponge or an absorbent cotton, the lithographic printing plate precursor is processed while rubbing the entire plate surface, and, after the end of the process, the lithographic printing plate precursor is sufficiently dried is preferably exemplified. In the case of an immersion process, for example, a method in which the lithographic printing plate precursor is immersed in a pad or a deep tank filled with an aqueous solution and stirred for approximately 60 seconds and then sufficiently dried while being rubbed with an absorbent cotton, a sponge, or the like is preferably exemplified.

In the development process, a device having a simplified structure and a simplified step is preferably used.

In a development process of the related art, a protective layer is removed by a prior water washing step, next, development is carried out using an alkaline developer, after that, an alkali is removed in a post water washing step, a gum process is carried out in a gum-pulling step, and the lithographic printing plate precursor is dried in the drying step.

In the present disclosure, it is possible to carry out development and gum pulling at the same time using a single liquid. Therefore, the post water washing step and the gum-pulling step are not particularly required, and it is preferable to carry out development and gum pulling using a single liquid and then carry out the drying step as necessary. As the gum, polymers, more preferably, a water-soluble polymer compound and a surfactant are exemplified.

Furthermore, it is preferable to carry out the removal of the protective layer, development, and gum pulling at the same time using a single liquid without carrying out the prior water washing step. In addition, it is preferable to, after development and gum pulling, remove the excess developer using a squeeze roller and then dry the lithographic printing plate precursor.

In the removal step (development process step) in the present disclosure, a method in which the lithographic printing plate precursor is immersed in the developer once or a method in which the lithographic printing plate precursor is immersed in the developer twice or more may be used. Among these, a method in which the lithographic printing plate precursor is immersed in the developer once or twice is preferred.

For the immersion, the exposed lithographic printing plate precursor may be immersed in a developer tank filled with the developer or the developer may be blown onto the plate surface of the exposed lithographic printing plate precursor by means of spraying or the like.

Meanwhile, in the present disclosure, even in the case of immersing the lithographic printing plate precursor in the developer twice or more, a case in which the lithographic printing plate precursor is immersed twice or more in the same developer or a developer and another developer (tired liquid) in which the components of the image-recording layer are dissolved or dispersed due to the development process is regarded as the development process using a single liquid (single liquid process).

In addition, in the development process, a rubbing member is preferably used, and, in a development bath for removing the non-image area of the image-recording layer, the rubbing member such as a brush is preferably installed.

The development process in the present disclosure can be carried out according to an ordinary method at a temperature of preferably 0°C to 60°C and more preferably 15°C to 40°C by, for example, immersing the exposed lithographic printing plate precursor in the developer and rubbing the lithographic printing plate precursor with a brush or drawing a process liquid prepared in an external tank using a pump, blowing the process liquid to the lithographic printing plate precursor from a spray nozzle, and rubbing the lithographic printing plate precursor with a brush. This development process can be continuously carried out a plurality of times. For example, after a developer prepared in an external tank is drawn using a pump and blown to the lithographic printing plate precursor from a spray nozzle, and the lithographic printing plate precursor is rubbed with a brush, again, it is possible to blow the developer from the spray nozzle and rub the lithographic printing plate precursor with the brush. In the case of carrying out the development process using an automatic developing machine, the developer becomes more tired due to an increase in the process amount, and thus it is preferable to restore the process capability using a supplementary liquid or a fresh developer.

In the development process in the present disclosure, it is also possible to use a gum coater or an automatic developing machine that has been known in the related art for presensitized plates (PS plates) and computer to plates (CTP). In the case of using an automatic developing machine, for example, it is possible to apply any method of a method in which a developer prepared in a development tank or a developer prepared in an external tank is drawn using a pump and blown to a lithographic printing plate precursor from a spray nozzle, a method in which a printing plate is immersed and transported in a liquid in a tank filled with a developer using a guide roll or the like, or a method in which only a necessary amount of a substantially unused developer is supplied to each plate. In any of the methods, a rubbing mechanism such as a brush or a moulton roller is more preferably provided. For example, it is possible to use commercially available automatic developing machines (Clean Out Unit C85/C125, Clean-Out Unit+ C85/120, FCF 85V, FCF 125V, FCF News (manufactured by Glunz & Jensen), Azura CX85, Azura CX125, Azura CX150 (AGFA GRAPHICS)). In addition, it is also possible to use a device into which a laser exposure portion and an automatic developing machine portion are integrally combined.

The method for producing a lithographic printing plate according to the embodiment of the present disclosure does not include, after the removal step, a step of washing a surface of an obtained lithographic printing plate with water and a step of desensitizing the surface of the obtained lithographic printing plate. In the method for producing a lithographic printing plate according to the embodiment of the present disclosure, a single liquid process is possible using the developer, and the water washing step and the desensitizing step are not necessary.

In addition, the method for producing a lithographic printing plate according to the embodiment of the present disclosure preferably includes, after the removal step, a step of drying the obtained lithographic printing plate.

The drying step can also be carried out using an oven or carried out by blowing dried air. In addition, both methods may be combined together. The drying temperature is preferably 30°C to 250°C and more preferably 35°C to 160°C. The drying time is preferably 3 seconds to 180 seconds and more preferably 5 seconds to 90 seconds. The drying step is carried out by appropriately combining a drying temperature and a drying time as long as the performance of the lithographic printing plate precursor is not adversely affected.

### Examples

Hereinafter, the present disclosure will be described in detail using examples, but the present disclosure is not limited thereto. Meanwhile, in the present examples, "parts" indicates "parts by mass" unless particularly otherwise described.

### (Examples 1 to 32 and Comparative Examples 1 to 6)

### <Production of Support 1>

In order to remove rolling oil on the surface of a 0.3 mm-thick aluminum plate 1 (material JIS-A-1050), a defatting process was carried out thereon using a 10% by mass aqueous solution of sodium aluminate at 50°C for 30 seconds, and then, the surface of the aluminum plate was grained using three implanted nylon brushes having hair diameters of 0.3 mm and a suspension of pumice having a median diameter of 25 µm and water (specific gravity: 1.1 g/cm³) and well washed with water. This plate was etched by being immersed in a 25% by mass aqueous solution of sodium hydroxide at 45°C for nine seconds, was washed with water, then, was further immersed in 20% by mass of nitric acid at 60°C for 20 seconds, and was washed with water. The etched amount of the grained surface at this time was approximately 3 g/m².

Next, an electrochemical roughening process was continuously carried out thereon using an alternating current voltage of 60 Hz. An electrolytic solution at this time was a 1% by mass aqueous solution of nitric acid (including 0.5% by mass of aluminum ions), and the liquid temperature was 50°C. The electrochemical roughening process was carried out thereon using an alternating current power supply waveform in which the time TP taken for the current value to reach the peak from zero was 0.8 msec and the duty ratio was 1:1, and the electrochemical roughening process was carried out using a trapezoidal rectangular wave alternating current and a carbon electrode as a counter electrode. As an auxiliary anode, ferrite was used. The current density was 30 A/dm² in terms of the peak value of the current, and 5% of the current coming from the power supply was divided into the auxiliary anode. Regarding the quantity of electricity during nitric acid electrolysis, the quantity of electricity was 175 C/dm² in a case in which the aluminum plate served as the positive electrode. After that, the plate was washed with water by means of spraying.

Next, an electrochemical roughening process was carried out thereon using the same method as nitric acid electrolysis in a 0.5% by mass aqueous solution of hydrochloric acid (including 0.5% by mass of aluminum ions) and an electrolytic solution having a liquid temperature of 50°C under a condition of the quantity of electricity of 50 C/dm² in a case in which the aluminum plate served as the positive electrode, and then, the plate was washed with water by means of spraying.

Next, 2.5 g/m² of a direct current anodized film was provided on this plate at a current density of 15 A/dm² using a 15% by mass aqueous solution of sulfuric acid (including 0.5% by mass of aluminum ions) as an electrolytic solution, then, washed with water and dried. The center line average roughness (Ra) of this substrate was measured using a needle having a diameter of 2 µm and was found to be 0.51 µm.

Next, the following undercoat layer liquid (1) was applied so that the dried coating amount reached 15 mg/m², thereby producing a support 1 that was used in the following experiment.

### <Undercoat layer liquid (1)>

- Compound for undercoat layer (1) having the following structure: 0.18 parts
- Hydroxyethyl iminodiacetic acid: 0.10 parts
- Methanol: 55.24 parts
- Water: 6.15 parts

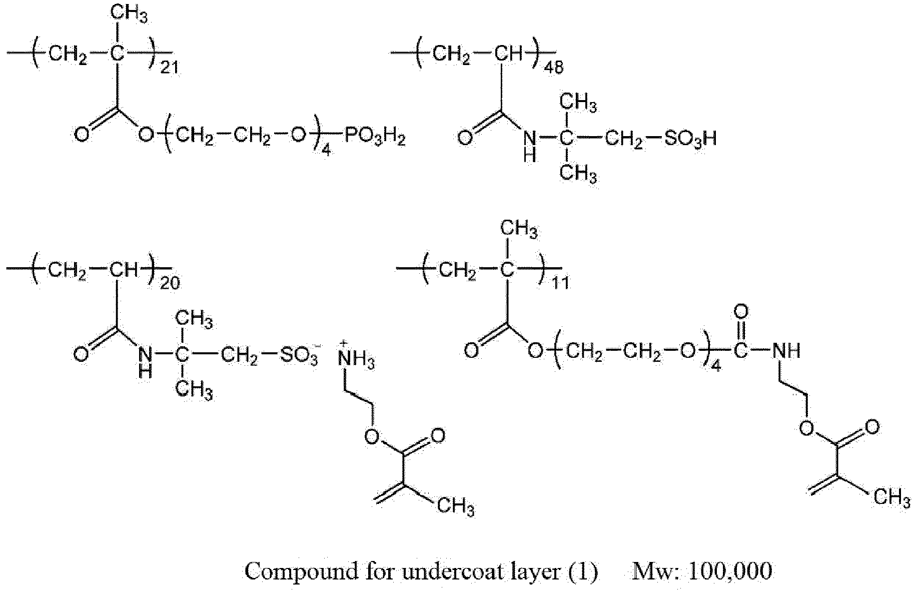

Meanwhile, numerical values on the lower right side of parentheses of individual constitutional units in the compound for an undercoat layer (1) represent mass ratios, and a numerical value on the lower right side of the ethyleneoxy unit represents the number of times of repetition.

### <Production of support 2>

### - Aluminum plate -

A molten metal was prepared using an aluminum alloy containing Si: 0.06% by mass, Fe: 0.30% by mass, Cu: 0.005% by mass, Mn: 0.001% by mass, Mg: 0.001% by mass, Zn: 0.001% by mass, and Ti: 0.03% by mass with a remainder being aluminum and an inevitable impurity, a molten metal process and filtration were carried out, and then an ingot having a thickness of 500 mm and a width of 1,200 mm was produced using a DC casting method. Unevenness on the surface was scraped away using a facing device so as to obtain an average thickness of 10 mm, and then the ingot was isothermally held at 550°C for approximately five hours and rolled using a hot roller when the temperature lowered to 400°C, thereby producing a 2.7 mm-thick rolled plate. Furthermore, a thermal process was carried out at 500°C using a continuous annealing machine, and then the rolled plate was finished to a thickness of 0.24 mm by cold rolling, thereby obtaining an aluminum plate of a JIS 1050 material. The width of this aluminum plate was set to 1,030 mm, and then a surface treatment described below was carried out on the aluminum plate.

### <Surface treatment>

The surface treatment was carried out by continuously carrying out a variety of processes (b) to (j) below.

Meanwhile, after each process and water washing, liquid was drained using a nip roller.

### (b) Alkali etching process

On the aluminum plate obtained above, an etching process was carried out by means of spraying using an aqueous solution having a sodium hydroxide concentration of 2.6% by mass, an aluminum ion concentration of 6.5% by mass, and a temperature of 70°C, thereby dissolving 6 g/m² of the aluminum plate. After that, the plate was washed with water by means of spraying.

### (c) Desmut process

A desmut process was carried out by means of spraying using an aqueous solution having a temperature of 30°C and a nitric acid concentration of 1% by mass (including 0.5% by mass of aluminum ions) and then the plate was washed with water by means of spraying. As the nitric acid aqueous solution used in the desmut process, a waste liquid of a step of carrying out an electrochemical roughening process in a nitric acid aqueous solution using an alternating current was used.

### (d) Electrochemical roughening process

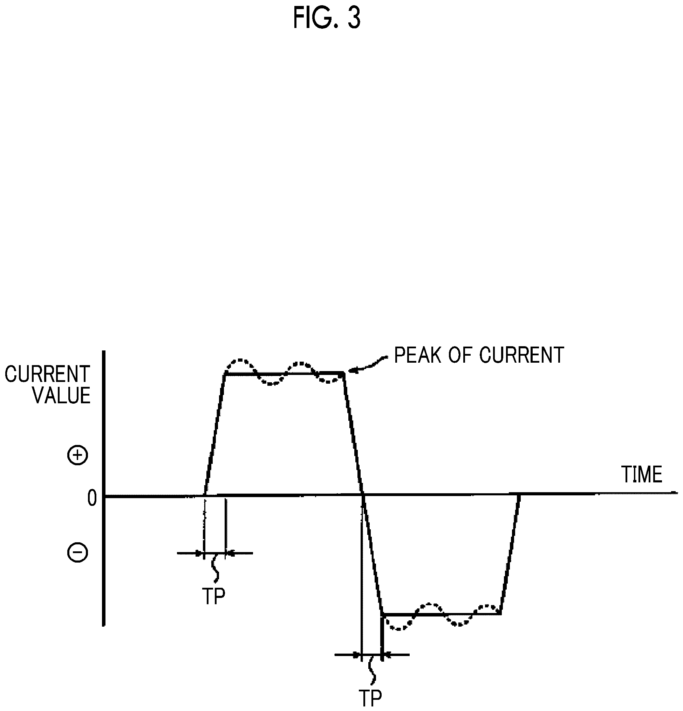

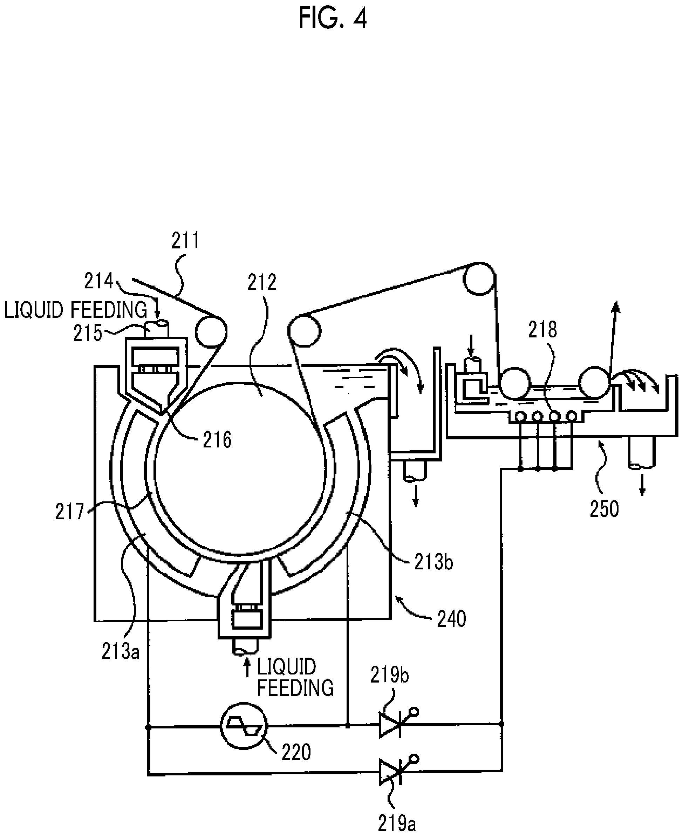

An electrochemical roughening process was continuously carried out using an alternating current voltage of 60 Hz. An electrolytic solution at this time was a 10.5 g/L aqueous solution of nitric acid (including 5 g/L of aluminum ions and 0.007% by mass of ammonium ions), and the liquid temperature was 50°C. The alternating current power supply waveform was a waveform illustrated in Fig. 3, and the electrochemical roughening process was carried out thereon using a trapezoidal rectangular wave alternating current in which the time TP taken for the current value to reach the peak from zero was 0.8 msec, a duty ratio of 1:1, and a carbon electrode as a counter electrode. As an auxiliary anode, ferrite was used. An electrolysis tank used was a tank illustrated in Fig. 4. The current density was 30 A/dm² in terms of the peak value of the current, and the quantity of electricity was 220 C/dm² in terms of the sum of the quantities of electricity in a case in which the aluminum plate was the positive electrode. Five percent of the current coming from the power supply was divided into the auxiliary anode. After that, the plate was washed with water by means of spraying.

### (e) Alkali etching process

On the aluminum plate, an etching process was carried out at 32°C by spraying an aqueous solution having a sodium hydroxide concentration of 26% by mass, an aluminum ion concentration of 6.5% by mass, 0.25 g/m² of the aluminum plate was dissolved, a smut component including, as a main body, aluminum hydroxide generated at the time of the electrochemical roughening process using the alternating current on the upper level was removed, and, additionally, the edge portion of the generated pit was dissolved to smoothen the edge portion. After that, the plate was washed with water by means of spraying.

### (f) Desmut process

A desmut process was carried out by spraying an aqueous solution having a sulfuric acid concentration of 15% by mass of a temperature of 30°C (including 4.5% by mass of aluminum ions) and then the plate was washed with water by means of spraying. As the nitric acid aqueous solution used in the desmut process, the waste liquid of the step of carrying out the electrochemical roughening process in the nitric acid aqueous solution using an alternating current was used.

### (g) Electrochemical roughening process

An electrochemical roughening process was continuously carried out using an alternating current voltage of 60 Hz. An electrolytic solution at this time was a 2.5 g/L aqueous solution of hydrochloric acid (including 5 g/L of aluminum ions), and the temperature was 35°C. The alternating current power supply waveform was a waveform illustrated in Fig. 3, and the electrochemical roughening process was carried out thereon using a trapezoidal rectangular wave alternating current in which the time TP taken for the current value to reach the peak from zero was 0.8 msec, a duty ratio of 1:1, and a carbon electrode as a counter electrode. As an auxiliary anode, ferrite was used. An electrolysis tank used was a tank illustrated in Fig. 4. The current density was 25 A/dm² in terms of the peak value of the current, and the quantity of electricity was 50 C/dm² in terms of the sum of the quantities of electricity in a case in which the aluminum plate was the positive electrode. After that, the plate was washed with water by means of spraying.

### (h) Alkali etching process

On the aluminum plate, an etching process was carried out at 32°C by spraying an aqueous solution having a sodium hydroxide concentration of 26% by mass, an aluminum ion concentration of 6.5% by mass, 0.1 g/m² of the aluminum plate was dissolved, a smut component including, as a main body, aluminum hydroxide generated at the time of the electrochemical roughening process using the alternating current on the upper level was removed, and, additionally, the edge portion of the generated pit was dissolved to smoothen the edge portion. After that, the plate was washed with water by means of spraying.

### (i) Desmut process

A desmut process was carried out by means of spraying using an aqueous solution having a temperature of 60°C and a sulfuric acid concentration of 25% by mass (including 0.5% by mass of aluminum ions) and then the plate was washed with water by means of spraying.

### (j) Anodization process

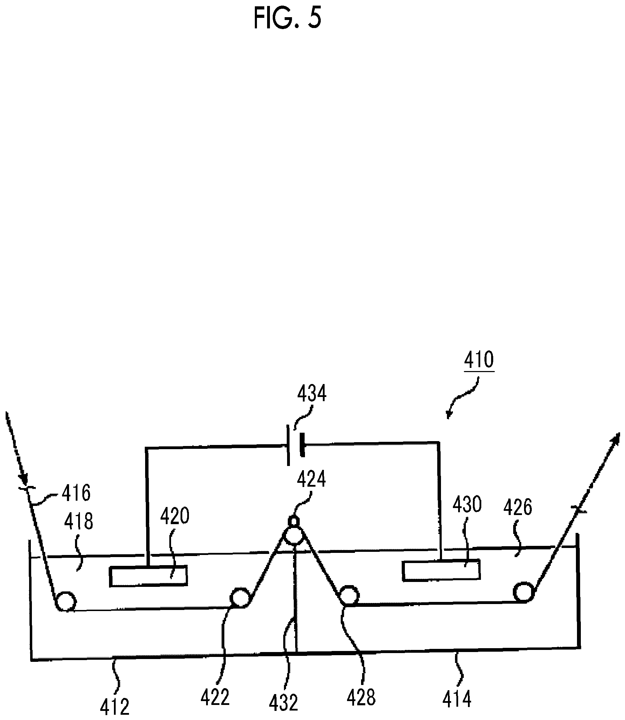

An anodization process was carried out using an anodization device having a structure illustrated in Fig. 5, thereby obtaining a support 2. As electrolytic solutions supplied to first and second electrolysis portions, sulfuric acid was used. All of the electrolytic solutions had a sulfuric acid concentration of 170 g/L (including 0.5% by mass of aluminum ions) and a temperature of 38°C. After that, the support was washed with water by means of spraying. The final oxide film amount was 2.7 g/m².

### <Coating fluid for undercoat layer (1)>

| | |
|---|---|
| • Compound for undercoat layer (2) having the following structure: | 0.18 parts |
| • Tetrasodium ethylenediaminetetraacetate: | 0.10 parts |
| • Polyoxyethylene lauryl ether: | 0.03 parts |
| • Water: | 61.39 parts |

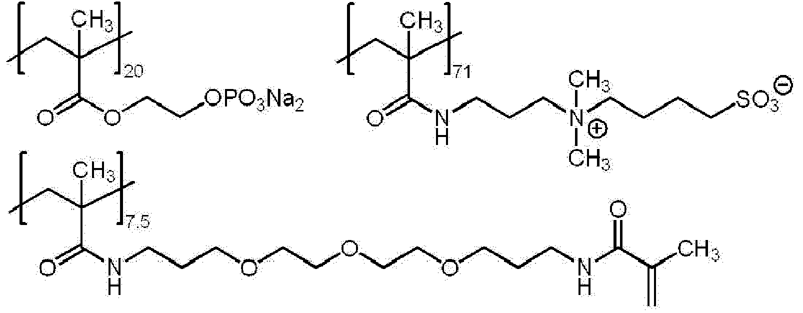

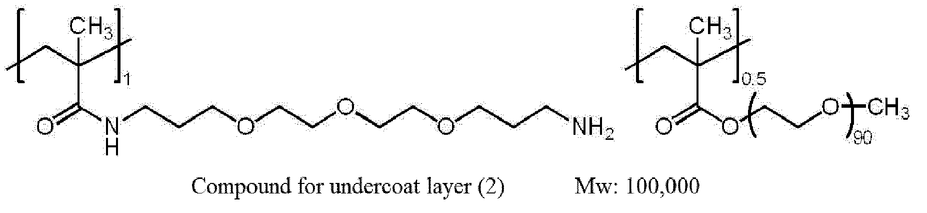

Meanwhile, numerical values on the lower right side of parentheses of individual constitutional units in the compound for an undercoat layer (2) represent mass ratios, and numerical values on the lower right-hand side of the ethyleneoxy units represent the numbers of times of repetition.

### [Production of lithographic printing plate precursor A]

### (3) Formation of image-recording layer

A coating fluid for an image-recording layer (1) having the following composition was applied onto the undercoat layer on the support 1 formed as described above by means of bar coating and then dried in an oven at 100°C for 60 seconds, thereby forming an image-recording layer having a dried coating amount of 1.0 g/m².

The coating fluid for the image-recording layer (1) was obtained by mixing and stirring the following photosensitive liquid (1) and a micro gel liquid (1) immediately before the coating.

### <Photosensitive liquid (1)>

- Binder polymer (1) [the following structure, Mw: 50,000, n: the number of ethylene oxide (EO) units=4]: 0.480 parts
- Infrared absorber (1) [the following structure]: 0.030 parts
- Borate compound [sodium tetraphenyl borate]: 0.014 parts
- Radical polymerization initiator (1) [the following structure]: 0.234 parts
- Radical polymerizable compound [tris(acryloyloxyethyl)isocyanurate, NK ester A-9300, manufactured by Shin-Nakamura Chemical Co., Ltd.]: 0.192 parts
- Low-molecular-weight hydrophilic compound (1) [tris(2-hydroxyethyl)isocyanurate]: 0.052 parts
- Anionic surfactant 1 [the following structure]: 0.099 parts
- Sensitization agent, phosphonium compound (1) [the following structure]: 0.12 parts
- Sensitization agent, ammonium group-containing polymer (1) [the following structure, reducing specific viscosity of 44 ml/g]: 0.035 parts
- Sensitization agent, benzyldimethyloctylammonium·PF₆ salt: 0.032 parts
- Coloring agent, ETHYL VIOLET [the following structure]: 0.030 parts
- Fluorine-based surfactant (1) [the following structure]: 0.02 parts
- 2-Butanone: 1.091 parts
- 1-Methoxy-2-propanol: 8.609 parts

### <Micro gel liquid (1)>

- Micro gel (1): 1.580 parts
- Distilled water: 1.455 parts

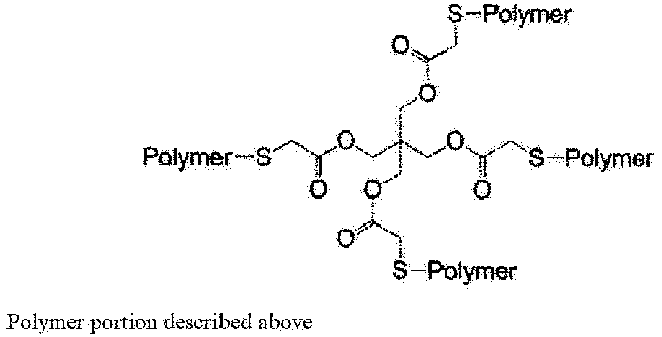

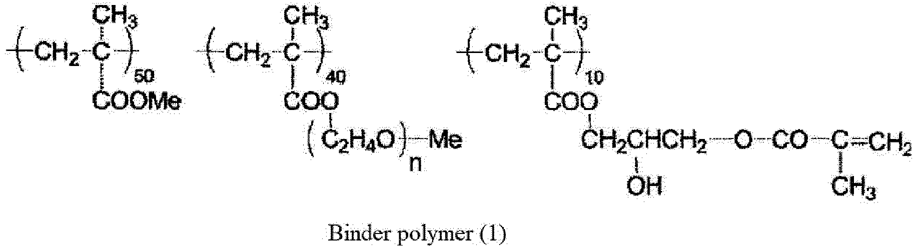

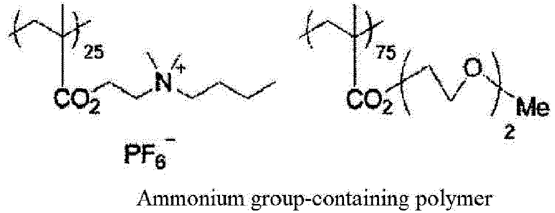

Meanwhile, Me represents a methyl group, and numbers on the lower right side of parentheses of individual constitutional units in the binder polymer (1) and the ammonium group-containing polymer represent molar ratios.

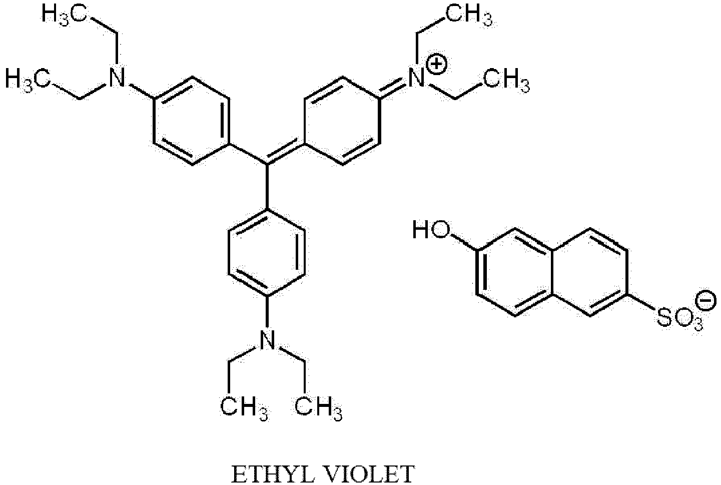

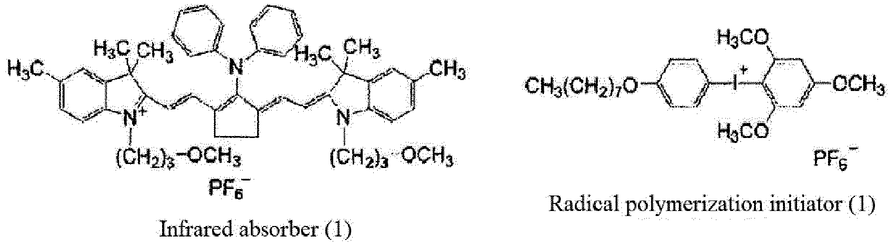

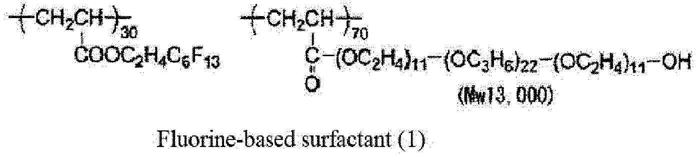

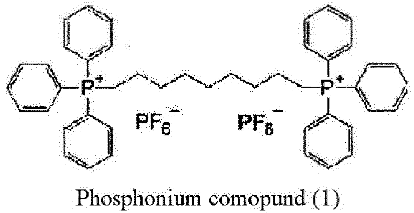

Meanwhile, numbers on the lower right side of parentheses of individual constitutional units in the fluorine-based surfactant (1) represent molar ratios, and numerical values on the lower right-hand side of the ethyleneoxy units or the propyleneoxy units represent the numbers of times of repetition.

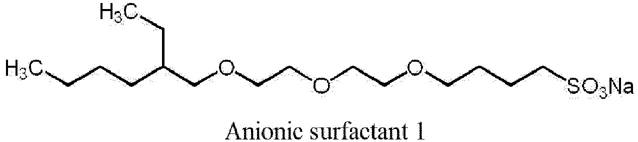

A method for synthesizing the micro gel (1) was as described below.

### - Synthesis of micro gel (1) -

As oil-phase components, an adduct of trimethylolpropane and xylene diisocyanate (manufactured by Mitsui Chemicals Inc., TAKENATE D-110N) (10 parts), dipentaerythritol pentaacrylate (manufactured by Sartomer Japan Inc., SR399) (5.54 parts), and BIONINE A-41C (manufactured by Takemoto Oil & Fat Co., Ltd.) (0.1 parts) were dissolved in ethyl acetate (17 parts). As a water-phase component, a 4% by mass aqueous solution of PVA-205 (40 parts) was prepared. The oil-phase components and the water-phase component were mixed together and emulsified using a homogenizer at 12,000 rpm for 10 minutes. The obtained emulsified substance was added to distilled water (25 parts), stirred at room temperature (25°C which will be true below) for 30 minutes, and stirred at 50°C for three hours. A micro gel liquid obtained as described above was diluted with distilled water so that the concentration of the solid content reached 15% by mass, and this was regarded as the micro gel (1). The average particle diameter of the micro gel was measured using a light scattering method and found out to be 0.2 µm.

### (4) Formation of protective layer

The coating fluid for a protective layer (1) having the following composition was applied onto the image-recording layer by means of bar coating and dried in an oven at 120°C for 60 seconds, and a protective layer having a dried coating amount of 0.15 g/m² was formed, thereby obtaining each of lithographic printing plate precursors (1) to (14).

### <Coating fluid for protective layer (1)>

- Inorganic lamellar compound dispersion liquid (1) (liquid obtained below): 1.5 parts
- Hydrophilic polymer (1) (solid content) [the following structure, Mw: 30,000]: 0.55 parts
- Six percent by mass aqueous solution of polyvinyl alcohol (CKS50 manufactured by The Nippon Synthetic Chemical Industry Co., Ltd., sulfonic acid-modified, degree of saponification: 99% by mol or higher, degree of polymerization: 300): 0.10 parts
- Six percent by mass aqueous solution of polyvinyl alcohol (PVA-405 manufactured by Kuraray Co., Ltd., degree of saponification: 81.5 mol%, degree of polymerization: 500): 0.03 parts
- Eighty percent by mass aqueous solution of a surfactant (RAPISOL A-80, trade name, manufactured by NOF Corporation): 0.011 parts
- Ion exchange water: 6.0 parts

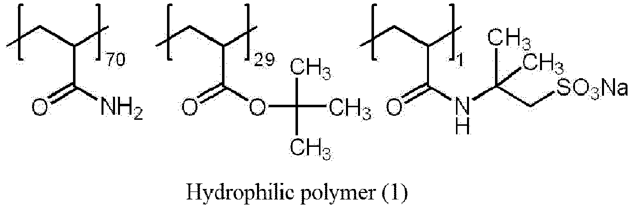

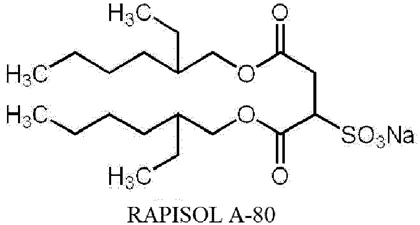

Meanwhile, numbers on the lower right side of parentheses of individual constitutional units in the hydrophilic polymer (1) represent molar ratios.

### <Preparation of inorganic lamellar compound dispersion liquid (1)>

Synthetic mica SOMASIF ME-100 (manufactured by Co-op Chemical Co., Ltd.) (6.4 parts) was added to ion exchange water (193.6 parts) and dispersed using a homogenizer until the average particle diameter (laser scattering method) reached 3 µm. The aspect ratio of the obtained dispersed particle was 100 or higher.

### [Production of lithographic printing plate precursor A']

A lithographic printing plate precursor A' was produced in the same manner as in the method for producing the lithographic printing plate precursor A except for the fact that, in the production of the lithographic printing plate precursor A, the support 2 was used instead of the support 1.

### [Production of lithographic printing plate precursor B]

### (1) Formation of image-recording layer

A coating fluid for an image-recording layer (2) described below was applied onto the support having an undercoat layer by means of bar coating and then dried in an oven at 70°C for 60 seconds, thereby forming an image-recording layer having a dried coating amount of 0.6 g/m².

### <Image-recording layer coating fluid (2)>

· Particle water dispersion liquid of specific polymer compound (particulate) [refer to the following production method]: Amount of 40% by mass of the total solid content of the image-recording layer
· Infrared absorbing dye (2) [the following structure]: 0.2 parts
· Radical polymerization initiator Irgacure 250 (manufactured by BASF): 0.5 parts
· Radical polymerizable compound SR-399 (manufactured by Sartomer Japan Inc.): 1.50 parts
· Mercapt-3-triazole: 0.2 parts
· Byk 336 (manufactured by BYK Additives & Instruments): 0.4 parts
· Klucel M (manufactured by Hercules Incorporated): 4.8 parts
· ELVACITE 4026 (manufactured by Ineos Acrylics): 2.5 parts
· Anionic/nonionic surfactant shown in Tables 1 to 3 below [the above structure]: 0.15 parts
· n-Propanol: 55.0 parts
· 2-Butanone: 17.0 parts

Meanwhile, the compounds expressed using trade names in the composition are as described below.
· IRGACURE 250: (4-Methoxyphenyl) [4-(2-methylpropyl)phenyl] iodonium=hexafluorophosphate (75% by mass propylene carbonate solution)
· SR-399: Dipentaerythritol pentaacrylate
· Byk 336: Modified dimethyl polysiloxane copolymer (a solution of 25% by mass of xylene and methoxypropyl acetate)
· Klucel M: Hydroxypropyl cellulose (2% by mass aqueous solution)
· ELVACITE 4026: Highly branched polymethyl methacrylate (a solution of 10% by mass of 2-butanone)

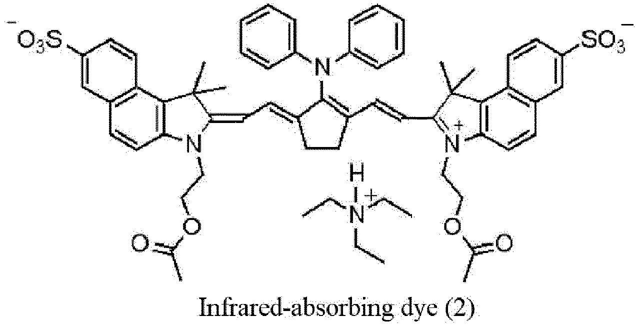

### <Production of polymer compound particle water dispersion liquid (1)>

A stirrer, a thermometer, a dropping funnel, a nitrogen introduction pipe, and a reflux cooler were provided to a four-neck flask, nitrogen gas was introduced thereinto, polyethylene glycol methyl ether methacrylate (PEGMA, the average number of the repeating units of ethylene glycol was 20) (10 parts), distilled water (200 parts), and n-propanol (200 parts) were added thereto while carrying out deoxidation by introducing nitrogen gas, and the components were heated until the inner temperature reached 70°C. Next, a mixture obtained by mixing styrene (St) (10 parts), acrylonitrile (AN) (80 parts), and 2,2'-azobisisobutyronitrile (0.8 parts) in advance was added dropwise thereto for one hour. A reaction continued for five hours after the end of the dropwise addition, then, 2,2'-azobisisobutyronitrile (0.4 parts) was added thereto, and the inner temperature was increased up to 80°C. Subsequently, 2,2'-azobisisobutyronitrile (0.5 parts) was added thereto for six hours. At a stage of continuing the reaction for a total of 20 hours, the production of a polymer compound proceeded 98% or more, and a polymer compound particle water dispersion liquid (1) including PEGMA/St/AN in a mass ratio of 10/10/80 was obtained. The particle size distribution of the polymer compound particles had the maximum value at a particle diameter of 150 nm.

Here, the particle size distribution was obtained by capturing an electron micrograph of the polymer compound particles, measuring the particle diameters of a total of 5,000 particles on the photograph, dividing the range of the obtained particle diameter measurement values from zero to the maximum value into 50 sections using a logarithmic scale, and plotting the appearance frequency of the respective particle diameters. Meanwhile, for a non-spherical particle, the particle diameter value of a spherical particle having the same particle area as the particle area on the photograph was considered as the particle diameter.

### [Production of lithographic printing plate precursor C]

### <Production of support 3>

A 0.19 mm-thick aluminum plate was defatted by being immersed in a 40 g/L aqueous solution of sodium hydroxide at 60°C for eight seconds and washed with desalinated water for two seconds. Next, on the aluminum plate, an electrochemical roughening process was carried out for 15 seconds using an alternating current in an aqueous solution containing 12 g/L of hydrochloric acid and 38 g/L of aluminum sulfate (18-hydrate) at a temperature of 33°C and a current density of 130 A/dm². After washed with desalinated water for two seconds, the aluminum plate was desmutted by being etched using a 155 g/L aqueous solution of sulfuric acid at 70°C for four seconds and washed with desalinated water at 25°C for two seconds. The aluminum plate was anodized in a 155 g/L aqueous solution of sulfuric acid for 13 seconds at a temperature of 45°C and a current density of 22 A/dm² and washed with desalinated water for two seconds. Furthermore, the aluminum plate was post-processed at 40°C for 10 seconds using a 4 g/L aqueous solution of polyvinyl phosphonate, washed with desalinated water at 20°C for two seconds, and dried. A support 3 obtained as described above had a surface roughness Ra of 0.21 µm and an anodized film amount of 4 g/m².

### (Production of lithographic printing plate precursor)

A water-based coating fluid for an image-recording layer containing components such as a thermoplastic resin particle, an infrared absorber, a polyglycerol compound, and the like described below was prepared, the pH was adjusted to 3.6, then, the coating fluid was applied onto the support 3 and dried at 50°C for one minute to form an image-recording layer, thereby producing a lithographic printing plate precursor C.

A thermoplastic particle polymer SAN, an infrared absorber IR-01, a polyglycerol compound PG-1, and another component PAA that were used in the coating fluid for an image-recording layer were as described below.
Thermoplastic resin particle SAN: Styrene/acrylonitrile copolymer (molar ratio: 50/50), Tg: 99°C, average particle diameter: 60 nm, amount applied: 0.7 (g/m²)
Polyglycerol compound PG-1: Polyglycerin PGL 10 (the number of repeating units: 10) (manufactured by Daicel Corporation), amount applied: 0.05 (g/m²)
Another component PAA: Polyacrylic acid, weight-average molecular weight: 250,000, amount applied: 0.09 (g/m²)
Infrared absorber IR-01: Infrared absorber having the following structure, amount applied: 1.20×10⁻⁴ (g/m²)

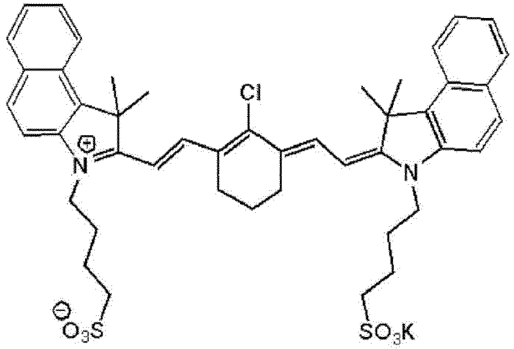

### [Image exposure]

The lithographic printing plate precursors were exposed using a LUXEL PLATESETTER T-6000III manufactured by Fujifilm Corporation which was equipped with an infrared semiconductor laser under conditions of an external surface drum rotation speed of 1,000 rpm (rotations per minute), a laser output of 70%, and a resolution of 2,400 dpi (dot per inch). Exposed images were provided with solid images and 50% halftone dot charts.

### [Development process]

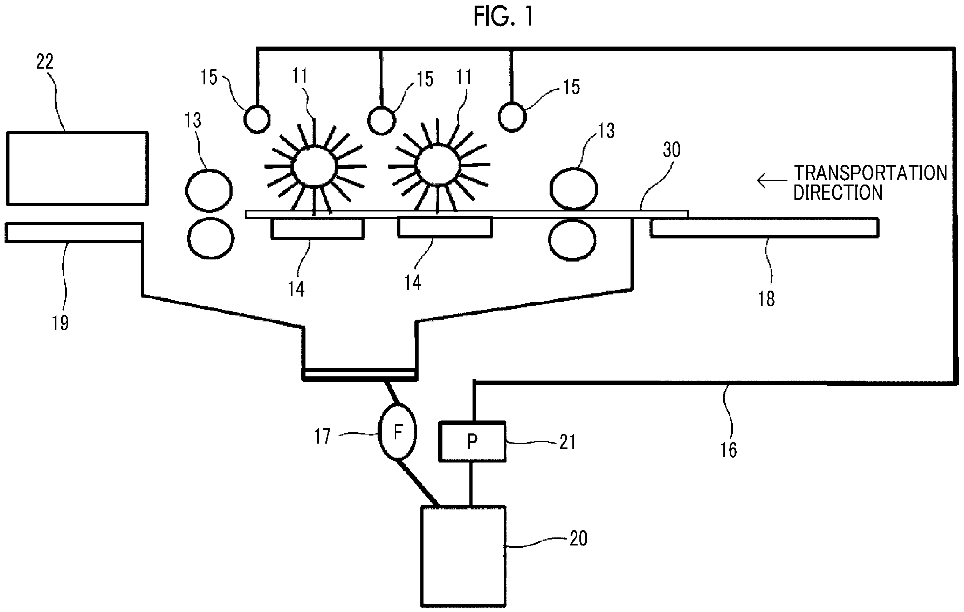

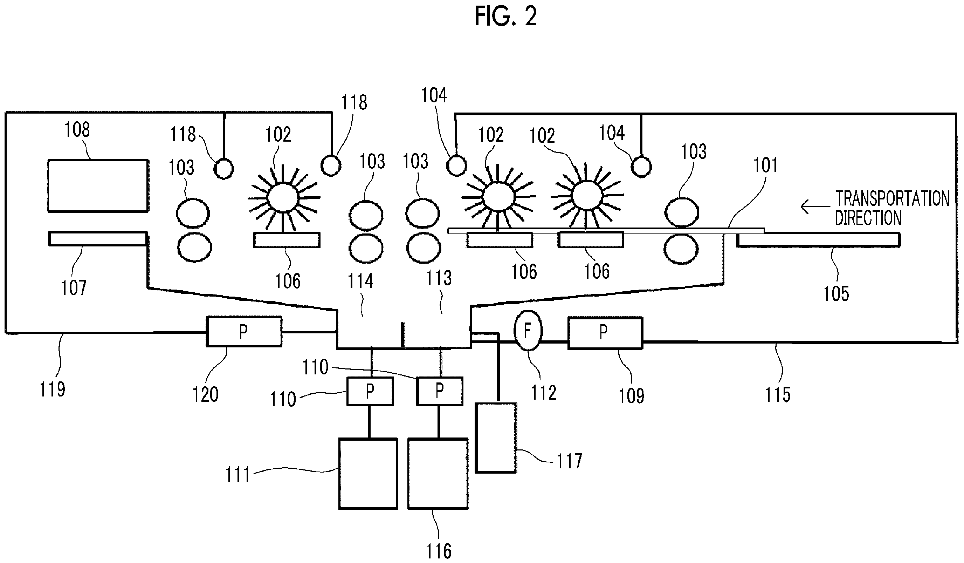

On the lithographic printing plate precursor, a development process was carried out using a development process device A exemplified in Fig. 1 or a development process device B exemplified in Fig. 2 that are shown in Table 4.

Here, "development procedure" refers to a complex process including not only the development of the image-recording layer but also one or more process selected from the group consisting of the removal, gum pulling, and drying of the protective layer.

Developers used are exemplified in Table 4.

The development process device A exemplified in Fig. 1 is an automatic process device having two rotary brush rolls 11. As the rotary brush roll 11, a brush roll having an outer diameter of 55 mm into which polybutylene terephthalate fibers (hair diameter: 200 µm, hair length: 7 mm) were implanted was used, and the rotary brush rolls were rotated in the same direction as a transportation direction 120 times per minute (the circumferential speed of the front end of the brush: 0.94 m/sec).

An exposed lithographic printing plate precursor 30 was transported through two pairs of transportation rolls 13 in a transportation direction illustrated in the drawing from a plate feeding table 18 to a plate releasing table 19 at a transportation rate of 60 cm/min on the transportation guide plates 14 so that the lithographic printing plate precursor 30 passed through between the rotary brush rolls 11 and the transportation guide plates 14 that faced the rotary brush rolls.

A developer stored in a developer tank 20 was supplied to three spray pipes 15 using a circulation pump 21 through a pipe line 16 and a filter 17 and supplied to the plate surface from the respective spray pipes 15 by means of showering. Meanwhile, the capacity of the developer tank 20 was 20 liters, and the developer was used in a circulated manner. A lithographic printing plate released from this development process device was dried using a dryer 22 without being washed.

The development process device B exemplified in Fig. 2 is an automatic process device having three rotary brush rolls 102. As the rotary brush roll 102, a brush roll having an outer diameter of 55 mm into which polybutylene terephthalate fibers (hair diameter: 200 µm, hair length: 7 mm) were implanted was used, and the rotary brush rolls were rotated in the same direction as a transportation direction 200 times per minute (the circumferential speed of the front end of the brush: 0.94 m/sec).

An exposed lithographic printing plate precursor 101 was transported through four pairs of transportation rolls 103 in a transportation direction illustrated in the drawing from a plate feeding table 105 to a plate releasing table 107 at a transportation rate of 160 cm/min on the transportation guide plates 106 so that the lithographic printing plate precursor 101 passed through between the rotary brush rolls 102 and the transportation guide plates 106 that faced the rotary brush rolls.

A developer stored in a first developer tank 113 was supplied to two spray pipes 104 using a circulation pump 109 through a pipe line 115 and a filter 112 and supplied to the plate surface from the respective spray pipes 104 by means of showering.

A developer stored in a second developer tank 114 was supplied to two spray pipes 118 using a circulation pump 120 through the pipe line 119 and supplied to the plate surface from the respective spray pipes 118 by means of showering.

Meanwhile, the capacity of a developer tank 111 was 20 liters, and the developer was used in a circulated manner. A lithographic printing plate released from this development process device was dried using a dryer 108 without being washed.

### [Preparation of developer]

Developers 1 to 24 and comparative developers 1 to 6 having compositions shown in Table 1 to Table 3 were produced respectively. The unit of the numerical values of individual components in Table 1 to Table 3 is "% by mass". Here, the pHs of the developers were adjusted using acetic acid and sodium hydroxide.

**[Table 1]**

| | | Developer (unit of content of each component: % by mass) | | | | | | | | | |
|---|---|---|---|---|---|---|---|---|---|---|---|
| | | 1 | 2 | 3 | 4 | 5 | 6 | 7 | 8 | 9 | 10 |
| Anionic surfactant | PELEX NBL | 1 | 1 | 1 | 2 | 5 | 4 | 5 | 2 | 2 | 2 |
| Nonionic surfactant | NEWCOL B13 | 2 | 2 | 2 | 5 | 2 | 8 | 10 | - | 5 | 5 |
| | NEWCOL B24 | - | - | - | - | - | - | - | 5 | - | - |
| Specific compound | 1-4 | 0.1 | 2 | 9 | 2 | 2 | 2 | 2 | 2 | - | 2 |
| | 1-7 | - | - | - | - | - | - | - | - | 2 | - |
| Benzyl alcohol | | 0.5 | 0.5 | 0.5 | 0.6 | 0.6 | 0.6 | 0.95 | 0.6 | 0.6 | 0.8 |
| Hydroxyalkylated starch (PENON JE-66) | | - | - | - | - | - | - | - | - | - | 0.05 |
| Defoamer (SILCOLAPSE432) | | 0.01 | 0.01 | 0.01 | 0.02 | 0.02 | 0.04 | 0.04 | 0.02 | 0.02 | 0.02 |
| pH | | 8.5 | 8.5 | 8.5 | 8.5 | 8.5 | 8.5 | 8.5 | 8.5 | 8.5 | 8.5 |

**[Table 2]**

| | | Developer (unit of content of each component: % by mass) | | | | | | | | | | |
|---|---|---|---|---|---|---|---|---|---|---|---|---|
| | | 11 | 12 | 13 | 14 | 15 | 16 | 17 | 18 | Comparative 1 | Comparative 2 | Comparative 3 |
| Anionic surfactant | PELEX NBL | 2 | 2 | 2 | 7 | - | - | - | 2 | 2 | 2 | 2 |
| | ELEMINOL MON2 | - | - | - | - | - | 2 | - | - | - | - | - |
| | NEWCOL B4SN | - | - | - | - | - | - | 2 | - | - | - | - |
| Nonionic surfactant | NEWCOL B 13 | 5 | 5 | 5 | - | 7 | 5 | 5 | - | 5 | 5 | 5 |
| | NEWCOL B24 | - | - | - | - | - | - | - | 5 | - | - | - |
| Specific compound | 1-4 | 2 | 2 | 2 | 2 | 2 | 2 | 2 | 2 | - | - | - |
| 1 -Hydroxy ethane-1,1 -diphosphonic acid | | - | - | - | - | - | - | - | - | - | - | 2 |
| Monoammonium phosphate | | - | - | - | - | - | - | - | - | - | 2 | - |
| Benzyl alcohol | | 0.8 | 0.8 | 0.6 | 0.6 | 0.6 | 0.6 | 0.6 | 0.6 | 0.6 | 0.6 | 0.6 |
| Defoamer (SILCOLAPSE432) | | 0.02 | 0.02 | 0.02 | 0.02 | 0.02 | 0.02 | 0.02 | 0.02 | 0.02 | 0.02 | 0.02 |
| pH | | 6.0 | 9.0 | 9.8 | 8.5 | 8.5 | 8.5 | 8.5 | 8.5 | 8.5 | 8.5 | 8.5 |

**[Table 3]**

| | | Developer (unit of content of each component: % by mass) | | | | | | | | |
|---|---|---|---|---|---|---|---|---|---|---|
| | | 19 | 20 | 21 | 22 | 23 | 24 | Comparative 4 | Comparative 5 | Comparative 6 |
| Anionic surfactant | PELEX NBL | 2 | 2 | 2 | 2 | 2 | 2 | 2 | 2 | 2 |
| Nonionic surfactant | NEWCOL B13 | 5 | 5 | 5 | 5 | 5 | 5 | 5 | 5 | 5 |
| Specific compound | 1-1 | 2 | - | - | - | - | - | - | - | - |
| | 1-4 | - | - | - | - | - | 2 | - | - | - |
| | 1-8 | - | 2 | - | - | - | - | - | - | - |
| | 1-9 | - | - | 2 | - | - | - | - | - | - |
| | 1-12 | - | - | - | 2 | - | - | - | - | - |
| | 1-13 | - | - | - | - | 2 | - | - | - | - |
| Succinic acid | | - | - | - | - | - | - | 2 | - | - |
| Malic acid | | - | - | - | - | - | - | - | 2 | - |
| Propanetricarboxylic acid | | - | - | - | - | - | - | - | - | 2 |
| Benzyl alcohol | | 0.6 | 0.6 | 0.6 | 0.6 | 0.6 | - | 0.6 | 0.6 | 0.6 |
| Defoamer (SILCOLAPSE432) | | 0.02 | 0.02 | 0.02 | 0.02 | 0.02 | 0.02 | 0.02 | 0.02 | 0.02 |
| pH | | 8.5 | 8.5 | 8.5 | 8.5 | 8.5 | 8.5 | 8.5 | 8.5 | 8.5 |

The details of the respective compounds shown in Table 1 to Table 3 will be described below.

Specific compounds 1-1, 1-4, 1-7 to 1-9, 1-12, and 1-13: 1-1, 1-4, 1-7 to 1-9, 1-12, and 1-13 described above
· PELEX NBL (sodium alkyl naphthalene sulfonate, anionic surfactant manufactured by Kao Corporation)
· ELEMINOL MON2 (disodium alkyl diphenyl ether disulfonate, anionic surfactant manufactured by Sanyo Chemical Industries, Ltd.)
· NEWCOL B4SN (polyoxyethylene aryl ether sulfuric acid ester salt, anionic surfactant manufactured by Nippon Nyukazai Co., Ltd.)
· NEWCOL B13 (polyoxyethylene aryl ether, nonionic surfactant manufactured by Nippon Nyukazai Co., Ltd.)
· NEWCOL B24 (polyoxyethylene aryl ether, nonionic surfactant manufactured by Nippon Nyukazai Co., Ltd.)
· 1-Hydroxyethane-1,1-diphosphonic acid (manufactured by Lion Specialty Chemicals Co., Ltd.)
· Monoammonium phosphate (manufactured by Wako Pure Chemical Corporation)
· Succinic acid (manufactured by Wako Pure Chemical Corporation)
· Malic acid (manufactured by Wako Pure Chemical Corporation)
· Propanetricarboxylic acid (manufactured by Tokyo Chemical Industry Co., Ltd.)
· Benzyl alcohol (manufactured by Wako Pure Chemical Corporation)
· Hydroxyalkylated starch (water-soluble polymer compound, PENON JE-66 manufactured by Nippon Starch Chemical Co., Ltd.)
· Defoamer (polydimethylsiloxane, SILCOLAPSE 432 manufactured by Bluester Silicones)

### [Performance evaluation]

### <Printing evaluation>

The exposed and developed lithographic printing plate was attached to a cylinder of a printer SOR-M manufactured by Heidelberger Druckmaschinen AG. Dampening water and ink were supplied thereto using dampening water (EU-3 (etchant manufactured by Fujifilm Corporation)/water/isopropyl alcohol=1/89/10 (capacity ratio)) and TRANS-G (N) black ink (manufactured by DIC Corporation), and 500 pieces of paper were printed thereon at a printing rate of 6,000 pieces per hour.

### <Scratch stain resistance>

Each of the lithographic printing plate precursors was exposed and developed, and scratches were provided to the obtained lithographic printing plate using a scratching tester in an environment with a temperature of 25°C and a humidity of 70%. As the scratching tester, HEIDON scratching intensity TESTER HEIDEN-18 was used, a 0.1 mmk sapphire needle was used, and a scratching load was set to 50 (g). Printing was carried out on the scratched plate, and whether or not a scratched portion turned into a printing stain was evaluated.
A: Does not turn into printing stains.
B: Printing stains that are too small to be visually recognized are found.
C: Small printing stains are visually recognized in a permissible range.
D: The scratched portion turns into a printing stain.

### <Development scum dispersion stability>

Each of the lithographic printing plate precursors was developed 1,000 m² using an automatic development process device, and then the status of scum (oil-form or solid-form scum attached to a member such as a tank wall or a roller) generated in a tank of the automatic development process device was observed. The status was evaluated according to the following standards.
A: A case in which no scum is generated
B: A case in which a small amount of scum is recognized, but no scum is attached to the surface of the developed lithographic printing plate.
C: A case in which the generation of scum is recognized, but scum is rarely attached to the surface of the developed lithographic printing plate.
D: A case in which scum is significantly generated, and scum is attached to the surface of the developed lithographic printing plate.

The evaluation results are summarized in Table 4.

**[Table 4]**

| | | Lithographic printing plate precursor | Developer | Development process device | Scratch stain resistance | Dispersion stability of development scum |
|---|---|---|---|---|---|---|
| | 1 | A' | 1 | A | C | C |
| | 2 | A' | 2 | A | A | C |
| | 3 | A' | 2 | B | A | C |
| | 4 | A' | 3 | A | A | C |
| | 5 | A' | 4 | A | A | A |
| | 6 | A' | 4 | B | A | A |
| | 7 | A' | 5 | A | A | A |
| | 8 | A' | 6 | A | A | A |
| | 9 | A' | 7 | A | A | A |
| | 10 | A' | 8 | A | A | A |
| | 11 | A' | 9 | A | A | A |
| | 12 | A' | 10 | A | A | A |
| | 13 | A' | 11 | A | A | A |
| | 14 | A' | 12 | A | A | A |
| | 15 | A' | 13 | A | A | A |
| | 16 | A | 4 | A | A | A |
| Example | 17 | A | 4 | B | A | A |
| | 18 | C | 4 | A | A | A |
| | 19 | C | 4 | B | A | A |
| | 20 | B | 4 | A | A | A |
| | 21 | B | 4 | B | A | A |
| | 22 | A' | 14 | A | A | C |
| | 23 | A' | 15 | A | C | C |
| | 24 | A' | 16 | A | A | A |
| | 25 | A' | 17 | A | A | A |
| | 26 | A' | 18 | A | A | A |
| | 27 | A' | 19 | A | B | A |
| | 28 | A' | 20 | A | B | A |
| | 29 | A' | 21 | A | B | A |
| | 30 | A' | 22 | A | B | A |
| | 31 | A' | 23 | A | C | B |
| | 32 | A' | 24 | A | B | C |
| Comparative Example | 1 | A' | Comparative 1 | A | D | A |
| | 2 | A' | Comparative 2 | A | D | A |
| | 3 | A' | Comparative 3 | A | D | A |
| | 4 | A' | Comparative 4 | A | D | D |
| | 5 | A' | Comparative 5 | A | D | C |
| | 6 | A' | Comparative 6 | A | D | C |

The disclosures of JP2017-037217 filed on February 28, 2017 is incorporated into the present specification by reference in its entirety.

All of documents, patent applications, and technical standards described in the present specification are incorporated into the present specification by reference as if the respective documents, patent applications, and technical standards are specifically and respectively described to be incorporated by reference.

### Explanation of References

11: rotary brush roll, 12: receiving roll, 13: transportation roll, 14: transportation guide plate, 15: spray pipe, 16: pipe line, 17: filter, 18: plate feeding table, 19: plate releasing table, 20: developer tank, 21: circulation pump, 22: dryer, 30: lithographic printing plate precursor, 101: lithographic printing plate precursor, 102: rotary brush roll, 103: transportation roll, 104: spray pipe, 105: plate feeding table, 106: transportation guide plate, 107: plate releasing table, 108: dryer, 109: circulation pump, 110: pump, 111, 116: developer tank, 112: filter, 113: first developer tank, 114: second developer tank, 115: pipe line, 117: waste liquid tank, 118: spray pipe, 119: pipe line, 120: circulation pump, 211: aluminum plate, 212: radial drum roller, 213a, 213b: main pole, 214: electrolysis process liquid, 215: electrolytic solution supply opening, 216: slit, 217: electrolytic solution path, 218: auxiliary anode, 219a, 219b: thyristor, 220: alternating current power supply, 240: main electrolysis tank, 250: auxiliary anode tank, 410: anodization process device, 412: power feeding tank, 414: electrolytic process tank, 416: aluminum plate, 418, 426: electrolytic solution, 420: power feeding electrode, 422, 428: roller, 424: nip roller, 430: electrolysis electrode, 432: tank wall, 434: direct current power supply

## Claims

1. A method for producing a lithographic printing plate comprising in order:
a step of preparing a lithographic printing plate precursor having an image-recording layer on a hydrophilic support;
a step of exposing the lithographic printing plate precursor in an image shape; and
a step of removing a non-exposed portion of the image-recording layer exposed in the lithographic printing plate precursor using a developer,
wherein the developer includes, at a content of more than 1.0% by mass and not more than 10% by mass of a total mass of the developer, a compound having at least one acidic group selected from the group consisting of a phosphate group, a phosphonate group, and a phosphinate group and one or more carboxy groups,
a pH of the developer is 5 to 10, and
after the removal step, a step of washing a surface of an obtained lithographic printing plate with water and a step of desensitizing the surface of the obtained lithographic printing plate are not provided.

2. The method for producing a lithographic printing plate according to claim 1,
wherein the developer further includes an anionic surfactant and a nonionic surfactant.

3. The method for producing a lithographic printing plate according to claim 2,
wherein a mass ratio (the nonionic surfactant to the anionic surfactant) between a content of the nonionic surfactant and a content of the anionic surfactant in the developer is 1.2:1.0 to 5.0:1.0.

4. The method for producing a lithographic printing plate according to claim 2 or 3,
wherein a total content of the nonionic surfactant and the anionic surfactant in the developer is 2% by mass to 20% by mass of a total mass of the developer.

5. The method for producing a lithographic printing plate according to any one of claims 1 to 4,
wherein the image-recording layer contains an infrared-absorbing colorant, a polymerization initiator, a polymerizable compound, and a binder polymer.

6. The method for producing a lithographic printing plate according to any one of claims 1 to 4,
wherein the image-recording layer contains an infrared-absorbing colorant, a polymerization initiator, a polymerizable compound, and a particulate polymer compound.

7. The method for producing a lithographic printing plate according to any one of claims 1 to 4,
wherein the image-recording layer contains an infrared-absorbing colorant and a thermoplastic resin particle.

8. The method for producing a lithographic printing plate according to any one of claims 1 to 7,
wherein the number of carboxy groups in the compound having at least one acidic group selected from the group consisting of a phosphate group, a phosphonate group, and a phosphinate group and one or more carboxy groups is 2 or more and 10 or less.

9. The method for producing a lithographic printing plate according to any one of claims 1 to 8,
wherein the developer does not include a water-soluble polymer compound or a content of the water-soluble polymer compound is more than 0% by mass and 0.05% by mass or less of the total mass of the developer.

10. The method for producing a lithographic printing plate according to any one of claims 1 to 9,
wherein the developer includes, at a content of 2.0% by mass to 10% by mass of a total mass of the developer, the compound having at least one acidic group selected from the group consisting of a phosphate group, a phosphonate group, and a phosphinate group and one or more carboxy groups.
